# EUROPEAN PATENT APPLICATION

(11) **EP 4 322 137 A1**
(43) Date of publication of application: **14.02.2024**
(21) Application number: 22815135.3
(22) Date of filing: 26.05.2022
(51) Int. Cl.: G09F 9/30, H01L 27/32, H01L 51/52, B32B 27/00

(54) **COMPOSITE STRUCTURE, FLEXIBLE SCREEN ASSEMBLY, AND FOLDABLE TERMINAL**

(30) Priority: 31.05.2021 CN 202110606183
(71) Applicant: Huawei Technologies Co., Ltd., Shenzhen, Guangdong 518129 (CN)
(72) Inventor: QIN, Yuan, Shenzhen, Guangdong 518129 (CN); LI, Yangyang, Shenzhen, Guangdong 518129 (CN); ZOU, Chun, Shenzhen, Guangdong 518129 (CN); YAO, Weiwei, Shenzhen, Guangdong 518129 (CN); SUN, Nanjian, Shenzhen, Guangdong 518129 (CN); CHEN, Taimeng, Shenzhen, Guangdong 518129 (CN); SU, Zhaoliang, Shenzhen, Guangdong 518129 (CN)
(74) Representative: Pfenning, Meinig & Partner mbB
(86) International application number: PCT/CN2022/095153
(87) International publication number: WO 2022/253089

(57) **Abstract**

Embodiments of this application provide a composite structure, including a substrate layer and a functional layer disposed on a surface of at least one side of the substrate layer. The substrate layer includes a first support member and a second support member that are disposed side by side and a bendable connecting member that is disposed between the first support member and the second support member and that is connected to the first support member and the second support member. A material of the first support member and the second support member includes a hard rubber fiber composite material, and the functional layer includes one or more of an electrically conductive layer, a thermally conductive layer, and an impact-resistant layer. The composite structure may be used for supporting a flexible display, and the first support member and the second support member are made of the hard rubber fiber composite material. The composite structure has high strength and a small mass, and can provide good rigid support for the flexible display and implement product lightweight, to improve competitiveness of a terminal product. In addition, the functional layer may be provided with functions such as electrical conductivity, thermal conductivity, impact resistance, and the like of the composite structure, to improve performance of the terminal product. Embodiments of this application further provide a foldable terminal including the composite structure.

## Description

This application claims priority to Chinese patent application No. 202110606183.1, entitled "COMPOSITE STRUCTURE, FLEXIBLE DISPLAY ASSEMBLY, AND FOLDABLE TERMINAL", filed with the China National Intellectual Property Administration on May 31, 2021, which is incorporated herein by reference in its entirety.

### TECHNICAL FIELD

Embodiments of this application relate to the field of flexible display technologies, and in particular, to a composite structure, a flexible display assembly, and a foldable terminal.

### BACKGROUND

With development of flexible display technologies, flexible displays are increasingly used in terminal devices. To maintain flatness and rigidity of screens of flexible displays of foldable terminals, a metal layer is usually disposed under a screen as an under-screen support mechanical part. A material of the metal layer is mainly a stainless steel and a titanium alloy. The stainless steel is a widely used material, but the stainless steel is heavy, which is not conducive to overall weight reduction of a foldable terminal. The titanium alloy is lighter, but costs of the titanium alloy are much higher than those of the stainless steel. In addition, rigidity and strength of the titanium alloy are lower than those of the stainless steel. Consequently, a risk of bending reliability of the titanium alloy is higher than that of the stainless steel, and the titanium alloy has not been widely used currently. To overcome a disadvantage of an under-screen support mechanical part made of a stainless steel or a titanium alloy, it is necessary to provide a flexible display support structure that can simultaneously implement high structural strength, lightweight, and low costs.

### SUMMARY

In view of this, embodiments of this application provide a composite structure, including a substrate layer and a functional layer. The substrate layer is made of a hard rubber fiber composite material, which has higher strength, a smaller mass, and lower costs compared with a metal material such as a stainless steel. The functional layer may provide the composite structure with functions such as electrical conductivity, thermal conductivity, impact resistance, and the like. The composite structure is used for supporting a flexible display, may provide the flexible display with good rigid support, has a small mass and low costs, and in addition can effectively implement functions such as electrical conductivity, thermal conductivity, impact resistance, and the like, so that product competitiveness of a foldable terminal is improved.

Specifically, a first aspect of embodiments of this application provides a composite structure. The composite structure includes a substrate layer and a functional layer disposed on a surface of at least one side of the substrate layer, where the substrate layer includes a first support member and a second support member that are disposed side by side and a bendable connecting member that is disposed between the first support member and the second support member and that is connected to the first support member and the second support member, a material of the first support member and the second support member includes a hard rubber fiber composite material, and the functional layer includes one or more of an electrically conductive layer, a thermally conductive layer, and an impact-resistant layer. The first support member and the second support member are made of the hard rubber fiber composite material, in other words, a fiber-reinforced hard rubber material, which has a small mass and high strength, can provide good rigid support for a flexible display, has a high weight reduction benefit, and has low material costs, so that product competitiveness of a foldable terminal is improved. The functional layer may be disposed to provide the composite structure with performance such as electrical conductivity, thermal conductivity, impact resistance, and the like, to implement functions such as electrical connection, heat dissipation, and drop resistance of the entire flexible display and a terminal product, meet a multi-functional requirement for a flexible display support structure on the market, and further improve market competitiveness of a foldable terminal product.

In an implementation of this application, the electrically conductive layer includes electrically conductive metal, and the electrically conductive layer has a single-layer or multi-layer structure. The electrically conductive layer may be disposed to enable the composite structure to be effectively electrically connected to another component. The electrically conductive layer may be formed on the substrate layer in a manner of adhesive bonding, electroless plating, electroless plating bonded to electroplating, or metal sheet press-fitting.

In an implementation of this application, the electrically conductive metal includes one or more of copper, silver, gold, nickel, and tin. When the electrically conductive layer has a single-layer structure, the electrically conductive layer may be formed by one type of electrically conductive metal, for example, a single copper layer or a single nickel layer; or may be formed by two or more types of electrically conductive metal, for example, the electrically conductive layer is formed by nickel and gold. Specifically, a local region of the electrically conductive layer may be a gold layer, and another region other than the gold layer is a nickel layer. When the electrically conductive layer has a multi-layer structure, materials of different layers may be the same or different, and each layer may be formed by one type of electrically conductive metal, or may be formed by two or more different types of electrically conductive metal. For example, the electrically conductive layer includes an inner layer and an outer layer, the inner layer is disposed on the substrate layer, and the outer layer is disposed on a side of the inner layer away from the substrate layer. Specifically, the inner layer may include at least one of gold, silver, and copper, the outer layer includes at least one of nickel and tin, and the outer layer may protect the inner layer. Alternatively, the inner layer may be a nickel layer, and the gold layer is locally plated on the nickel layer.

In an implementation of this application, the thermally conductive layer includes one or more of a thermally conductive silicone sheet, a thermally conductive silicone grease, a thermally conductive double-sided tape, a thermally conductive graphite sheet, a graphene sheet, and a graphene oxide sheet. The thermally conductive layer may be disposed to provide the composite structure with a good thermal conductivity function, to provide an effective channel for heat dissipation of the flexible display and the entire terminal product. The thermally conductive layer may be formed on the substrate layer in a manner of adhesive bonding or thermal fusion.

In an implementation of this application, the impact-resistant layer includes one or more of silicone rubber, a thermoplastic elastomer (TPE), polyurethane acrylate (PUA), polyvinyl chloride (PVC) soft rubber, and polyurethane (PU). The impact-resistant layer may be disposed to improve capabilities of the composite structure and the flexible display to resist external impact, to help maintain stability of the composite structure and improve drop-resistant performance of the terminal product. The impact-resistant layer may be formed on the substrate layer in a manner of adhesive bonding or thermal fusion.

In an implementation of this application, the functional layer may be disposed on one side of the substrate layer, or may be disposed on two sides of the substrate layer. The functional layer may completely cover the substrate layer, or may partially cover the substrate layer. For example, the partially covering the substrate layer may be that the functional layer covers only surfaces of the first support member and the second support member of the substrate layer, and does not cover the bendable connecting member. When the functional layers are disposed on two sides of the substrate layer, materials, quantities of layers, thicknesses, and the like of the functional layers on the two sides may be the same, or may be different. The electrically conductive layer, the thermally conductive layer, and the impact-resistant layer may be disposed on the substrate layer in any sequence in a laminated manner.

In an implementation of this application, the hard rubber fiber composite material includes at least one fiber layer and a hard rubber material cured on the fiber layer.

In an implementation of this application, the fiber layer includes unidirectional fiber fabric and/or woven fiber fabric. In other words, a fiber weaving manner of each fiber layer may be unidirectional weaving, or may be multi-directional weaving.

In an implementation of this application, the hard rubber material includes rigid resin and/or rigid rubber. A support member used for supporting a main body of the flexible display needs to have high rigidity, and rigid resin and/or rigid rubber may be selected to meet a rigidity requirement.

In an implementation of this application, the hard rubber material includes one or more of epoxy resin, phenolic resin, amino resin, unsaturated polyester, silyl ether resin, polyolefin, polyamide, polyoxymethylene, polycarbonate, polyphenylene ether, and polysulfone.

In an implementation of this application, the fiber layer includes one or more of glass fiber, carbon fiber, aramid fiber, aluminum oxide fiber, ultra-high-molecular-weight polyethylene fiber, and poly(p-phenylene benzobisoxazole) fiber.

In an implementation of this application, a mass content of the fiber in the hard rubber fiber composite material is 10% to 80%. An increase in fiber content can improve strength of the hard rubber fiber composite material.

In an implementation of this application, the hard rubber fiber composite material includes a plurality of fiber layers, and the plurality of fiber layers and the hard rubber material form a composite laminate in which the fiber and hard rubber are alternately laminated; or the plurality of fiber layers are laminated to form a fiber stack, and the hard rubber material is cured on the fiber stack.

In an implementation of this application, a material of the bendable connecting member includes one or more of an organic flexible material, a soft rubber fiber composite material, a bendable hard rubber fiber composite material, and a bendable metal material. All the foregoing four materials can implement bending performance of the bendable connecting member, to cooperate with folding and unfolding of the flexible display. The soft rubber fiber composite material and the organic flexible material can further obtain a weight reduction benefit.

In an implementation of this application, the organic flexible material includes one or more of fluorine rubber, silicone rubber, a thermoplastic elastomer, polyvinyl chloride, polyimide, polyethylene terephthalate, a cyclic olefin polymer, a liquid crystal polymer, and polydimethylsiloxane.

In an implementation of this application, the soft rubber fiber composite material includes at least one fiber layer and a soft rubber material cured on the fiber layer; and the soft rubber material includes one or more of fluorine rubber, silicone rubber, and a thermoplastic elastomer.

In an implementation of this application, a mass content of the fiber in the soft rubber fiber composite material is 10% to 80%.

In an implementation of this application, the soft rubber fiber composite material includes a plurality of fiber layers, and the plurality of fiber layers and the soft rubber material form a composite laminate in which the fiber and soft rubber are alternately laminated; or the plurality of fiber layers are laminated to form a fiber stack, and the soft rubber material is cured on the fiber stack.

In an implementation of this application, the bendable metal material includes one or more of a stainless steel, a titanium alloy, and an aluminum alloy. Specifically, to better implement bending performance, the bendable metal material may be a porous stainless steel, a porous titanium alloy, or a porous aluminum alloy.

In an implementation of this application, when the bendable connecting member is made of the soft rubber fiber composite material, the composite structure includes an integrally woven fiber layer that continuously exists in the first support member, the second support member, and the bendable connecting member. The composite structure may be an integrally woven fiber layer including one or more layers.

In an implementation of this application, the bendable hard rubber fiber composite material has a porous structure. The bendable hard rubber fiber composite material may form a porous structure by performing laser hole-cutting on the hard rubber fiber composite material, to implement bending performance.

In an implementation of this application, when the bendable connecting member is made of the bendable hard rubber fiber composite material, the bendable connecting member and the first support member and/or the second support member may be an integrally formed structure. When the substrate layer is an integrally formed structure, the substrate layer includes an integrally woven fiber layer and a hard rubber layer that continuously exist in the first support member, the second support member, and the bendable connecting member. The substrate layer is an integrally formed structure, which helps to implement high structural stability of the substrate layer as a whole.

In an implementation of this application, a thickness of the composite structure is 0.1 mm to 5 mm. The thickness of the composite structure may be specifically designed according to performance of a material and an actual application requirement of the product. The composite structure has a plate or sheet form as a whole.

In an implementation of this application, the first support member, the bendable connecting member, and the second support member are combined in a manner of hot press-fitting, adhesive bonding, splicing, or embedding, or the bendable connecting member and the first support member and/or the second support member are an integrally formed structure.

The composite structure provided in the first aspect of embodiments of this application is characterized by high strength, high rigidity, small mass, low costs, and functionalization, and has bending performance. The composite structure may be used in a foldable terminal product, to implement lightweight and functionalization of a product while meeting requirements such as strength and rigidity, and improve competitiveness of a foldable terminal product.

A second aspect of embodiments of this application provides a terminal, including the composite structure according to the first aspect of embodiments of this application. The composite structure may be an under-screen support structure used as a flexible display, or may be used as another functional component. The terminal includes a flexible display and a composite structure disposed below the flexible display.

A third aspect of embodiments of this application provides a flexible display assembly, including a flexible display and a flexible display support structure used for supporting the flexible display. The flexible display support structure is made by using the composite structure according to the first aspect of embodiments of this application. The foregoing composite structure is used as the flexible display support structure, so that product lightweight and functionalization can be implemented while strength, rigidity, and bending performance of the flexible display support structure are met. Compared with a stainless steel flexible display support structure, a weight is reduced by more than 60%, and costs are low.

An embodiment of this application further provides a foldable terminal, including the flexible display assembly according to the third aspect of embodiments of this application. A flexible display includes a bending region and non-bending regions on two sides of the bending region, a flexible display support structure is disposed on an outer surface of the flexible display, the first support member and the second support member of the flexible display support structure respectively correspond to the non-bending regions on two sides of the flexible display, and the bendable connecting member corresponds to the bending region of the flexible display. According to the foldable terminal provided in this embodiment of this application, the flexible display support structure has high strength, can provide sufficient rigid support for the flexible display, and has small mass and low costs. In addition, the flexible display support structure can further implement functions such as electrical connection, heat dissipation, and drop resistance of the flexible display and the foldable terminal, to improve product competitiveness and user experience.

### BRIEF DESCRIPTION OF DRAWINGS

FIG. 1 is a schematic diagram of a structure of a foldable terminal 10 according to an embodiment of this application;
FIG. 2 is a schematic diagram of a structure of a flexible display support structure 30 according to an embodiment of this application;
FIG. 3 is a schematic diagram of a structure of a substrate layer 100 according to an embodiment of this application;
FIG. 4 is a schematic diagram of a structure of a foldable terminal 10 according to an embodiment of this application;
FIG. 5 is a schematic diagram of a structure of a cross section of a flexible display support structure 30 in FIG. 1 in an A-A' direction according to an embodiment;
FIG. 6A and FIG. 6B are schematic diagrams of a structure of a cross section of a flexible display support structure 30 in FIG. 1 in an A-A' direction according to an embodiment;
FIG. 7 is a schematic diagram of a structure of a cross section of a flexible display support structure 30 in FIG. 1 in an A-A' direction according to an embodiment;
FIG. 8A and FIG. 8B are schematic diagrams of a structure of a cross section of a flexible display support structure 30 in FIG. 1 in an A-A' direction according to an embodiment;
FIG. 9 is a schematic diagram of a structure of a cross section of a flexible display support structure 30 in FIG. 1 in an A-A' direction according to an embodiment;
FIG. 10 is a schematic diagram of a structure of a cross section of a flexible display support structure 30 in FIG. 1 in an A-A' direction according to an embodiment;
FIG. 11A, FIG. 11B, and FIG. 11C are schematic diagrams of a structure of a cross section of a flexible display support structure 30 in FIG. 1 in an A-A' direction;
FIG. 12 is a schematic diagram of a structure of a cross section of a flexible display support structure 30 in FIG. 1 in an A-A' direction according to an embodiment;
FIG. 13 is a schematic diagram of a structure of a cross section of a flexible display support structure 30 in FIG. 1 in an A-A' direction according to an embodiment;
FIG. 14 is a schematic diagram of a structure of a hard rubber fiber composite material according to an embodiment of this application;
FIG. 15 is a schematic diagram of a structure of fiber multidirectional weaving according to an embodiment of this application;
FIG. 16 is a schematic diagram of a structure of a hard rubber fiber composite material according to another embodiment of this application;
FIG. 17 is a schematic diagram of a structure of a hard rubber fiber composite material according to another embodiment of this application;
FIG. 18 is a schematic diagram of stacking of a plurality of fiber weaving layers of a fiber layer at a plurality of angles according to an embodiment of this application;
FIG. 19 is a schematic diagram of a structure of a flexible display support structure including an integrally woven fiber layer according to an embodiment of this application;
FIG. 20 is a flowchart of a preparation process of a hard rubber fiber composite material according to an embodiment of this application;
FIG. 21 is a flowchart of a preparation process of a hard rubber fiber composite material according to another embodiment of this application; and
FIG. 22A to FIG. 22E are schematic diagrams of a connection manner between a first support member made of a hard rubber fiber composite material and a bendable connecting member according to an embodiment of this application.

### DESCRIPTION OF EMBODIMENTS

The following describes embodiments of this application with reference to accompanying drawings in embodiments of this application.

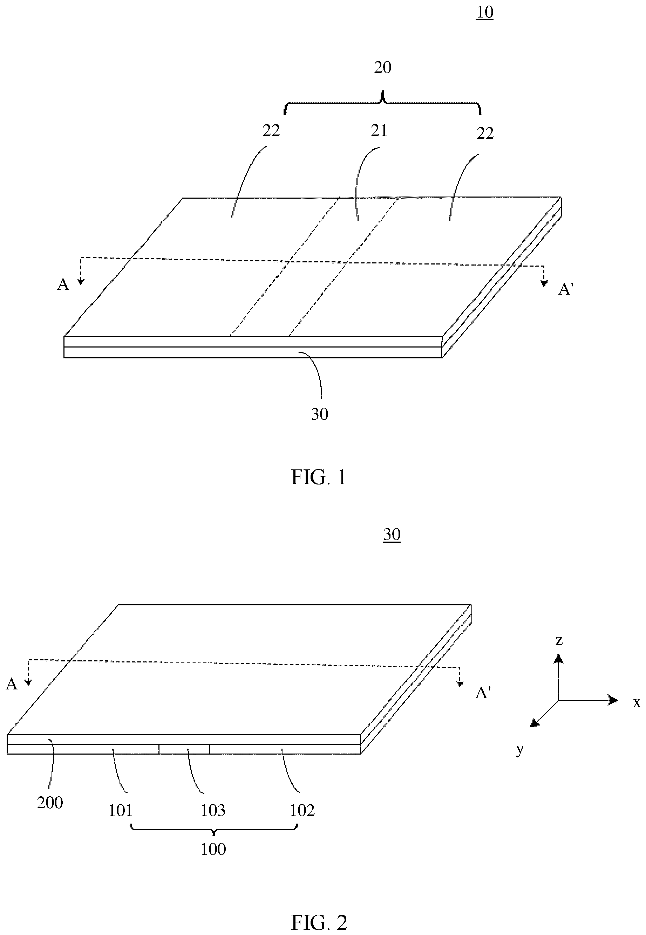

Refer to FIG. 1. An embodiment of this application provides a foldable terminal 10. The foldable terminal 10 may be a terminal product such as a mobile phone, a tablet computer, a notebook computer, a gaming laptop, an e-book reader, an in-vehicle computer, a display, a wearable device, or the like. The foldable terminal 10 includes a flexible display 20 and a flexible display support structure 30 that is attached to a side of the flexible display 20 away from a display surface. The flexible display 20 includes a bending region 21 and non-bending regions 22 located on two sides of the bending region 21, and surfaces of the non-bending regions 22 on two opposite sides are planar. The flexible display 20 is bendable, and may be bent in the bending region 21, to implement folding and unfolding of the flexible display 20. For example, the flexible display 20 may be an active matrix organic light-emitting diode (active matrix organic light-emitting diode, AMOLED) display that uses a flexible resin material such as polyethylene terephthalate (polyethylene terephthalate, PET) as a substrate, or may be a display of another type or in another form.

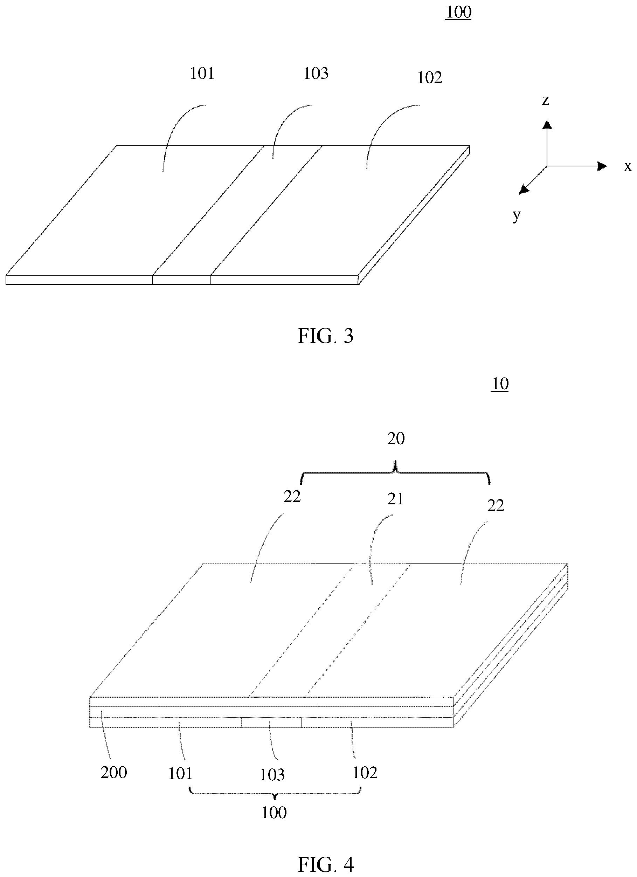

Refer to FIG. 2 and FIG. 3. The flexible display support structure 30 provided in this embodiment of this application is made of a composite structure. The composite structure includes a substrate layer 100 and a functional layer 200 disposed on the substrate layer 100. The substrate layer 100 includes a first support member 101, a bendable connecting member 103, and a second support member 102 that are disposed side by side. The bendable connecting member 103 is disposed between the first support member 101 and the second support member 102. Two opposite sides of the bendable connecting member 103 are respectively connected to the first support member 101 and the second support member 102. The first support member 101, the bendable connecting member 103, and the second support member 102 are disposed side by side in a first direction (an X direction in FIG. 2). A material of the first support member 101 and the second support member 102 includes a hard rubber fiber composite material. Specifically, the first support member 101 and the second support member 102 are plate-shaped hard rubber fiber composite panels. The functional layer 200 includes one or more of an electrically conductive layer, a thermally conductive layer, and an impact-resistant layer. The functional layer 200 may be disposed on a surface on one side or surfaces on two sides of the substrate layer 100. When the functional layer 200 is disposed only on a surface of one side of the substrate layer 100, the functional layer 200 may be located on a side of the substrate layer 100 close to the flexible display 20, or may be located on a side of the substrate layer away from the flexible display 20. The functional layer 200 may be formed on the substrate layer 100 through electroplating, electroless plating, bonding, press-fitting, or the like.

In an implementation of this application, the flexible display support structure 30 may be bonded to a surface of the side of the flexible display 20 away from the display surface through an adhesive, to support the flexible display 20. In other words, the substrate layer 100 or the functional layer 200 may be bonded to the flexible display 20 by an adhesive, and different regions of the flexible display support structure 30 may be tightly and firmly bonded to the flexible display 20 by a same adhesive or different adhesives. In an implementation of this application, a length and a width (in other words, sizes in the X direction and a Y direction in FIG. 2) of the flexible display support structure 30 are consistent with or basically consistent with a length and a width of the flexible display 20.

Refer to FIG. 1 and FIG. 4. The flexible display support structure 30 is attached to a side of the flexible display 20 away from the display surface, and is used for carrying the flexible display 20 that supports the foldable terminal. The first support member 101 and the second support member 102 of the substrate layer 100 correspond to the non-bending regions 22 of the flexible display 20, and the bendable connecting member 103 corresponds to the bending region 21 of the flexible display 20. When the foldable terminal 10 is unfolded, the bending region 21 of the flexible display 20 and the bendable connecting member 103 that supports the bending region 21 are unfolded together. When the foldable terminal 10 is unfolded, the bending region 21 of the flexible display 20 and the bendable connecting member 103 and the functional layer 200 that support the bending region 21 are unfolded together. When an included angle between the first support member 101 and the second support member 102 is less than 180°, the flexible display 20 is in a bent state. When the included angle between the first support member 101 and the second support member 102 is equal to 180°, the flexible display 20 is in an unfolded state. The flexible display support structure 30 may support the flexible display 20 in a process of folding or unfolding the flexible display 20 to ensure flatness of the flexible display 20, and may protect a non-display surface of the flexible display 20. According to the flexible display support structure 30 provided in this embodiment of this application, the first support member 101 and the second support member 102 in the substrate layer 100 are made of a hard rubber fiber composite material. The hard rubber fiber composite material has high strength, and has smaller mass than a metal material such as a stainless steel. Therefore, the hard rubber fiber composite material can provide good rigid support for the flexible display, and have a high weight reduction benefit, to help improve product competitiveness of the foldable terminal. The functional layer 200 may be disposed to provide the flexible display support structure 30 with performance such as electrical conductivity, thermal conductivity, impact resistance, and the like, to meet a product function requirement of the flexible display support structure 30.

In an implementation of this application, the functional layer 200 may include one or more of an electrically conductive layer, a thermally conductive layer, and an impact-resistant layer, and may further include a functional layer having another function as required. In other words, the functional layer 200 includes at least one of an electrically conductive layer, a thermally conductive layer, and an impact-resistant layer. The functional layer 200 may include one or more electrically conductive layers. The functional layer 200 may include one or more thermally conductive layers. The functional layer 200 may include one or more impact-resistant layers. A thickness of the functional layer 200 may be 5 µm to 500 µm. The thickness of the functional layer 200 is 5 µm to 500 µm, and is a total thickness of the functional layer on one side of the substrate layer 100. In some embodiments, the thickness of the functional layer 200 may be 10 µm to 200 µm. In some embodiments, the thickness of the functional layer 200 may be 6 µm to 100 µm. The functional layer 200 may be disposed on one side of the substrate layer 100, or may be disposed on two sides of the substrate layer 100. The functional layer 200 may completely cover the substrate layer 100, or may partially cover the substrate layer 100. When the functional layers 200 are disposed on two sides of the substrate layer 100, materials, quantities of layers, thicknesses, and the like of the functional layers 200 on the two sides may be the same, or may be different. The electrically conductive layer, the thermally conductive layer, and the impact-resistant layer may be selectively disposed on one side or two sides of the substrate layer 100 according to an actual requirement. The functional layer 200 may include an electrically conductive layer, or may include a thermally conductive layer, or may include an impact-resistant layer, or may include an electrically conductive layer and a thermally conductive layer, or may include an electrically conductive layer and an impact-resistant layer, or may include a thermally conductive layer and an impact-resistant layer, or may include an electrically conductive layer, a thermally conductive layer, and an impact-resistant layer. Optionally, the functional layer 200 may further include a functional layer having another function. The electrically conductive layer, the thermally conductive layer, and the impact-resistant layer may be disposed on the substrate layer 100 in any sequence in a laminated manner. Optionally, the impact-resistant layer is located on the outermost side, and the impact-resistant layer is located on an outer side and may be closer to the flexible display, to better protect the flexible display. In an embodiment, the functional layer 200 includes an electrically conductive layer, a thermally conductive layer, and an impact-resistant layer that are sequentially disposed on the substrate layer 100. Such a lamination sequence facilitates process preparation, and facilitates functional implementation of each functional layer.

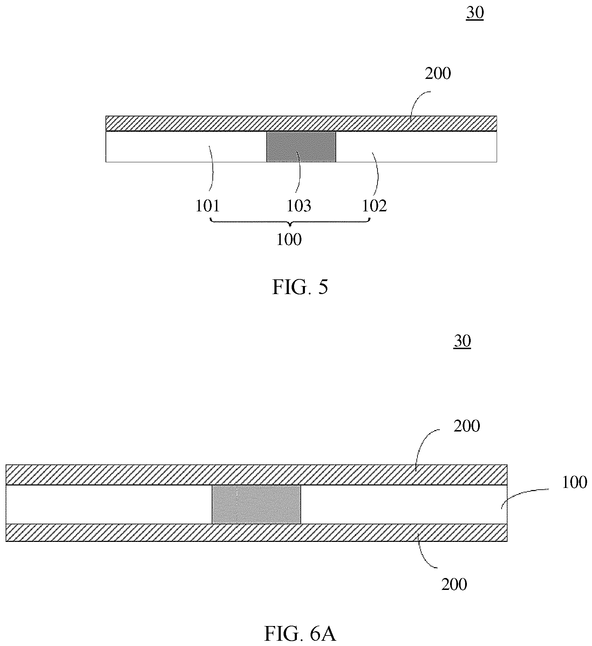

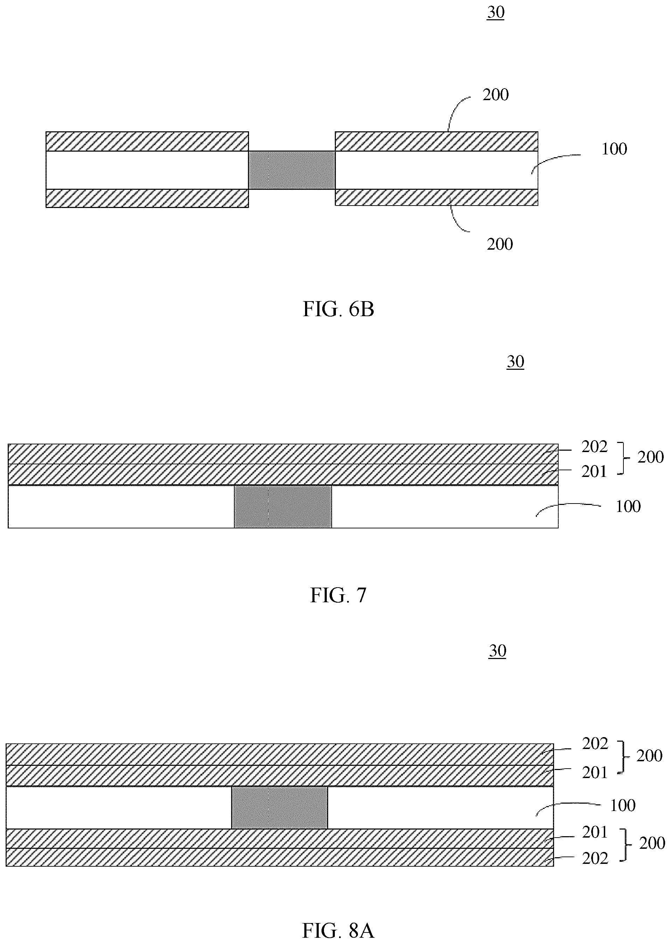

Refer to FIG. 5, FIG. 6A, and FIG. 6B. In an implementation of this application, the functional layer 200 is a single functional layer, in other words, the functional layer 200 includes an electrically conductive layer, a thermally conductive layer, or an impact-resistant layer disposed on one side or two sides of the substrate layer 100. For example, in an embodiment, the functional layer 200 includes an electrically conductive layer. In another embodiment, the functional layer 200 includes a thermally conductive layer. In another embodiment, the functional layer 200 includes an impact-resistant layer. When the functional layers 200 are disposed on two sides of the substrate layer 100, the functional layers 200 on the two sides may be functional layers having a same function, for example, two sides are electrically conductive layers; or may be functional layers having different functions, for example, an electrically conductive layer is provided on one side, and a thermally conductive layer is disposed on the other side. The functional layer 200 may completely cover a surface of the substrate layer 100 as shown in FIG. 6A, or may partially cover a surface of the substrate layer 100 as shown in FIG. 6B. Specifically, the functional layer 200 covers only surfaces of the support members 101 and 102 on the two sides, and does not cover a surface of the bendable connecting member 103.

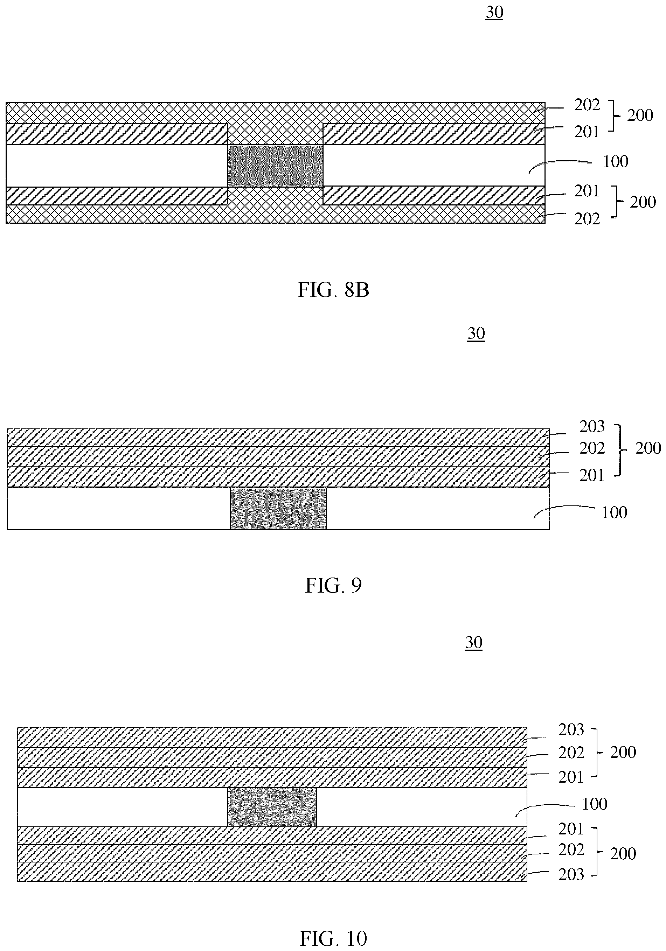

Refer to FIG. 7, FIG. 8A, and FIG. 8B. In another implementation of this application, the functional layer 200 is double functional layers, including a first functional layer 201 and a second functional layer 202. The first functional layer 201 and the second functional layer 202 are any two of an electrically conductive layer, a thermally conductive layer, and an impact-resistant layer. In other words, the functional layer 200 includes two material layers having different functions. For example, in an embodiment, the functional layer 200 includes an electrically conductive layer and an impact-resistant layer. In an embodiment, the functional layer 200 includes an electrically conductive layer and a thermally conductive layer. In an embodiment, the functional layer 200 includes a thermally conductive layer and an impact-resistant layer. A sequence of arranging the two functional layers may be not limited. The first functional layer 201 and the second functional layer 202 may completely cover or partially cover the surface of the substrate layer 100. In some embodiments, as shown in FIG. 8A, both the first functional layer 201 and the second functional layer 202 completely cover the surface of the substrate layer 100. In some embodiments, as shown in FIG. 8B, the first functional layer 201 covers only the surfaces of the support members on the two sides, and does not cover the surface of the bendable connecting member; and the second functional layer 202 completely covers the substrate layer 100.

Refer to FIG. 9 and FIG. 10. In another implementation of this application, the functional layer 200 is a plurality of functional layer, including a first functional layer 201, a second functional layer 202, and a third functional layer 203. The first functional layer 201, the second functional layer 202, and the third functional layer 203 are three functional layers: an electrically conductive layer, a thermally conductive layer, and an impact-resistant layer. A sequence of arranging the three functional layers may be not limited.

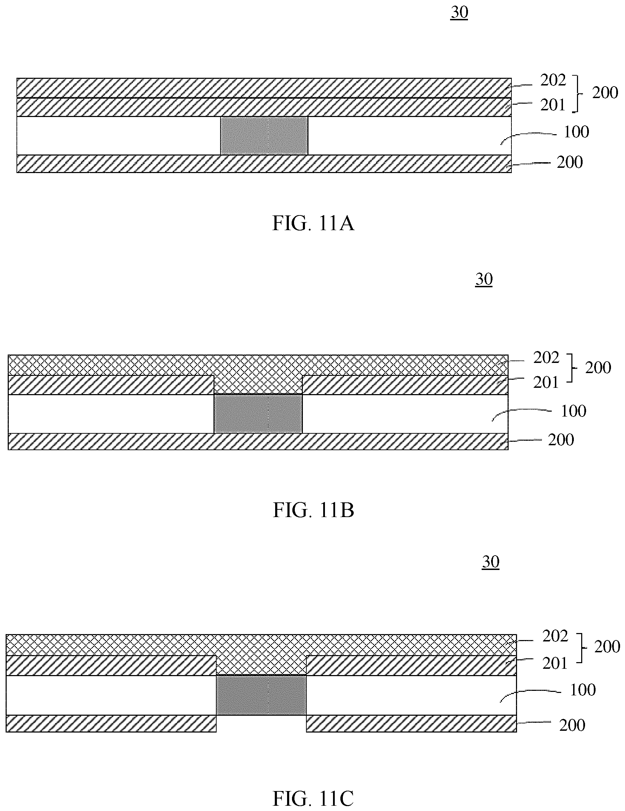

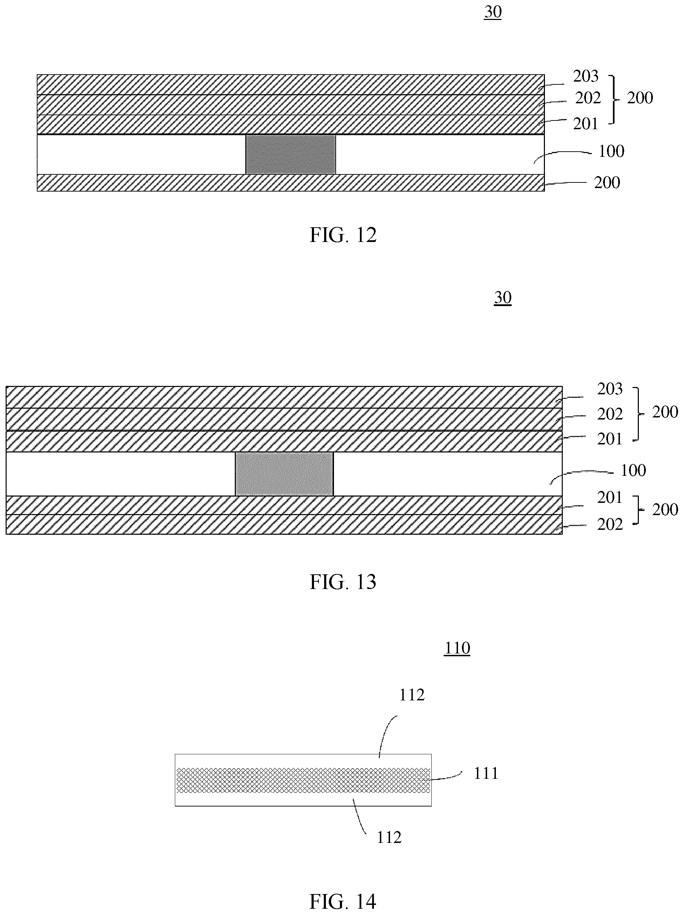

In some other implementations of this application, when the functional layers 200 are disposed on two sides of the substrate layer 100, as shown in FIG. 11A, FIG. 11B, and FIG. 11C, a single functional layer is disposed on one side of the substrate layer 100, and double functional layers are disposed on the other side; or as shown in FIG. 12, a single functional layer is disposed on one side of the substrate layer 100, and a plurality of functional layers are disposed on the other side; or as shown in FIG. 13, double functional layers are disposed on one side of the substrate layer 100, and a plurality of functional layers are disposed on the other side.

In an implementation of this application, the electrically conductive layer includes electrically conductive metal, and the electrically conductive layer may have a single-layer or multi-layer structure. The electrically conductive layer may be disposed to provide the flexible display support structure 30 with an electrical conduction function, so that the flexible display support structure 30 is effectively electrically connected to another component of the terminal 10, to compensate for a problem that when the substrate layer 100 is made of a non-electrically conductive material as a whole, the flexible display support structure 30 cannot be electrically connected to the another component of the terminal 10.

In an implementation of this application, the electrically conductive metal may include one or more of copper, silver, gold, nickel, and tin. When the electrically conductive layer has a single-layer structure, the electrically conductive layer may be formed by one type of electrically conductive metal, for example, a single copper layer or a single nickel layer; or may be formed by two or more types of electrically conductive metal. For example, the electrically conductive layer is formed by nickel and gold. A local region of the electrically conductive layer may be a gold layer, and another region other than the gold layer is a nickel layer. In another example, the electrically conductive layer is formed by nickel and copper. A local region of the electrically conductive layer is a copper layer, and another region other than the copper layer is a nickel layer. Alternatively, copper and nickel are used in all regions of the electrically conductive layer. When the electrically conductive layer has a multi-layer structure, materials of different layers may be the same or different, and each layer may be formed by one type of electrically conductive metal, or may be formed by two or more types of electrically conductive metal. For example, the electrically conductive layer includes an inner layer and an outer layer, the inner layer is disposed on the substrate layer, and the outer layer is disposed on a side of the inner layer away from the substrate layer. Specifically, the inner layer may include at least one of gold, silver, and copper, the outer layer includes at least one of nickel and tin, and the outer layer may protect the inner layer. Alternatively, the inner layer may be a nickel layer, and the gold layer is locally plated on the nickel layer. The flexible display support structure 30 has an electrical conduction function, and can meet an electrical connection requirement.

The electrically conductive layer may be formed on the substrate layer 100 in a manner of adhesive bonding, electroless plating, electroless plating bonded to electroplating, or metal sheet press-fitting. In an implementation, the electrically conductive layer is formed on the substrate layer 100 in an electroless plating manner. A specific process may include:
(1) The two sides of the substrate layer 100 are acid cleaned or alkaline cleaned to remove surface oil stain. When a region of the bendable connecting member includes non-metal, the region of the bendable connecting member of the substrate layer needs to be covered during the acid cleaning or alkaline cleaning. When the region of the bendable connecting member is made of a metal material, it may not be necessary to cover the region of the bendable connecting member.
(2) Subsequently, catalysis is performed, to deposit a layer of catalyst on the surface of the substrate layer 100. The catalyst may be specifically a catalyst containing palladium.
(3) The substrate layer 100 is immersed in a plating solution for electroless plating, to form a metal electrically conductive layer, and is washed and dried to obtain a composite structure having an electrically conductive layer. When the region of the bendable connecting member is covered, the electrically conductive layer covers only the surfaces of the support members on the two sides, and does not cover the surface of the bendable connecting member. When the bendable connecting member is not covered, the electrically conductive layer covers the entire surface of the substrate layer, in other words, covers the surfaces of the bendable connecting member and the support members on the two sides. In a process of plating the electrically conductive layer, the bendable connecting member including non-metal is covered, so that the bendable connecting member can be protected from corrosion and damage.

In an implementation of this application, the thermally conductive layer may include one or more of a thermally conductive silicone sheet, a thermally conductive silicone grease, a thermally conductive double-sided tape, a thermally conductive graphite sheet, a graphene sheet, and a graphene oxide sheet. The thermally conductive layer may be a single-layer or multi-layer structure. The thermally conductive layer may be disposed to provide the flexible display support structure 30 with a good thermal conductivity function, to facilitate heat dissipation of the flexible display and the entire terminal product. Specifically, the flexible display support structure 30 has a thermal conduction function, and may transfer heat generated by a battery inside the terminal and the like to a side of the display, and finally dissipate the heat to the outside of the terminal. The thermally conductive layer may be formed on the substrate layer 100 in a manner of adhesive bonding or thermal fusion (hot press-fitting).

In an implementation of this application, the impact-resistant layer may include one or more of silicone rubber, a thermoplastic elastomer (TPE), polyurethane acrylate (PUA), polyvinyl chloride (PVC) soft rubber, and polyurethane (PU). The impact-resistant layer has a buffer function, and the impact-resistant layer may be a single-layer or multi-layer structure. The thermoplastic elastomer (TPE) may include, but is not limited to, one or more of thermoplastic polyurethane (TPU), a thermoplastic polyester elastomer (TPEE), a styrene-based thermoplastic elastomer, a polyolefin-based thermoplastic elastomer (POE), a polyether ester-based thermoplastic elastomer, and a polyamide-based thermoplastic elastomer. The impact-resistant layer may be disposed to provide the flexible display support structure 30 with a capability of resisting external impact, to help protect the display and improve drop-resistant performance of the terminal product. When the impact-resistant layer is disposed only on one side of the substrate layer 100, the impact-resistant layer is located on the side of the substrate layer facing the display, so that the impact-resistant layer can better protect the display from drop impact. The impact-resistant layer may be formed on the substrate layer 100 in a manner of adhesive bonding or thermal fusion.

Refer to FIG. 14. A hard rubber fiber composite material 110 in this application includes at least one fiber layer 111 and a hard rubber material 112 cured on the fiber layer 111. In an implementation of this application, the hard rubber material 112 includes rigid resin and/or rigid rubber. In this application, specific types of the rigid resin and the rigid rubber are not specifically limited, and can meet an application requirement of an electronic device, provided that the rigid resin and the rigid rubber cooperate with fiber to provide sufficient rigid support for a flexible display. Specifically, the hard rubber material 112 includes, but is not limited to, one or more of epoxy resin, phenolic resin, amino resin, unsaturated polyester, silyl ether resin, polyolefin, polyamide, polyoxymethylene, polycarbonate, polyphenylene ether, and polysulfone. It may be understood that, to reduce an overall weight of the flexible display support structure as much as possible, a hard rubber material of relatively small mass may be selected on a premise that mechanical support is met. The hard rubber material 112 may be cured on the fiber layer 111 by using a solution impregnating method or a hot melting method in combination with a hot press-fitting process.

In an implementation of this application, the fiber in the fiber layer 111 is continuous fiber, and may specifically include, but is not limited to, one or more of glass fiber, carbon fiber, aramid fiber, aluminum oxide fiber, ultra-high-molecular-weight polyethylene fiber, and poly(p-phenylene benzobisoxazole) fiber. The ultra-high-molecular-weight polyethylene fiber is fiber spinning by using polyethylene with a molecular weight > 1 million. The fiber layer 111 may be woven by one type of fiber, or may be woven by two or more types of fiber. Performance advantages of various types of fiber may be combined by weaving different types of fiber.

In an implementation of this application, a mass content of the fiber in the hard rubber fiber composite material may be 10% to 80%. Specifically, the mass content of the fiber in the hard rubber fiber composite material may be, for example, 10%, 20%, 30%, 40%, 50%, 60%, 70%, or 80%. Fiber content in the hard rubber fiber composite material may be adjusted according to a specific rigid support requirement and in combination with a mechanical property of the selected rigid resin or rigid rubber. Generally, when the fiber content is higher, the overall weight of the hard rubber fiber composite material is larger, and it is more beneficial to weight reduction. In some implementations, in combination with rigid support performance and a weight reduction requirement, the mass content of the fiber in the hard rubber fiber composite material is 30% to 70%.

In an implementation of this application, a fiber weaving manner of each fiber layer 111 may be unidirectional weaving, or may be multi-directional weaving. In other words, the fiber layer 111 may be unidirectional fiber fabric, or may be woven fiber fabric. The unidirectional fiber fabric, in other words, fiber single axial-direction weaving, is fabric that has a large number of textile yarns in one direction (usually warp or weft unidirectional fabric) and only a small number of usually fine yarns in another direction. Therefore, all strength of the fabric is in one direction. The woven fiber fabric is textile fabric in which fiber is woven in a plurality of axial directions, a large quantity of textile yarns exist in a plurality of directions, and the strength of the final fabric is distributed in a plurality of axial directions. For example, warp and weft biaxial weaving, in other words, 0°/90° weaving, means that fiber of fiber fabric is distributed in two axial directions, angles of the two axial directions are respectively 0° and 90°, and an angle between fiber in the two axial directions is 90°. In another example, 45° weaving (in other words, +45°/-45°) means that fiber of the fiber fabric is distributed in two axial directions, angles of the two axial directions are respectively +45° and -45°, and an included angle between the fiber in the two axial directions is 90 degrees.

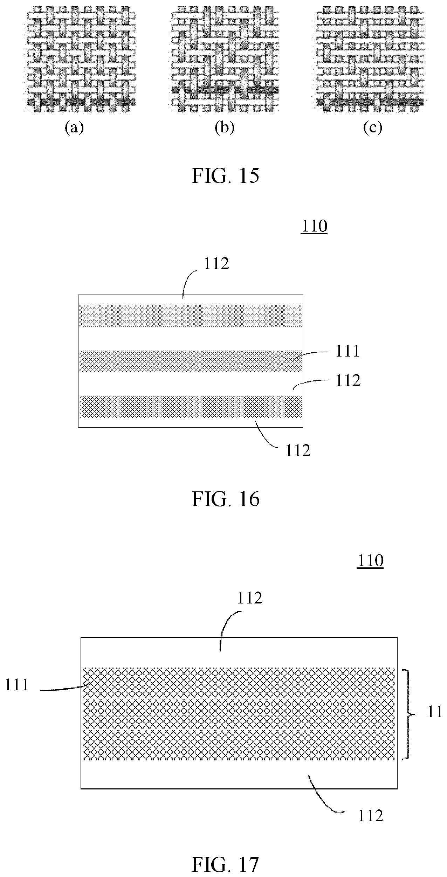

In an implementation of this application, a specific weaving form of fiber multi-directional weaving is not limited. Specifically, a form of multi-directional weaving may be plain weaving shown in (a) in FIG. 15, or may be twill weaving shown in (b) in FIG. 15, or may be the satin weaving shown in (c) in FIG. 15, or the like. In FIG. 15, (a), (b), and (c) all show 0°/90° biaxial weaving.

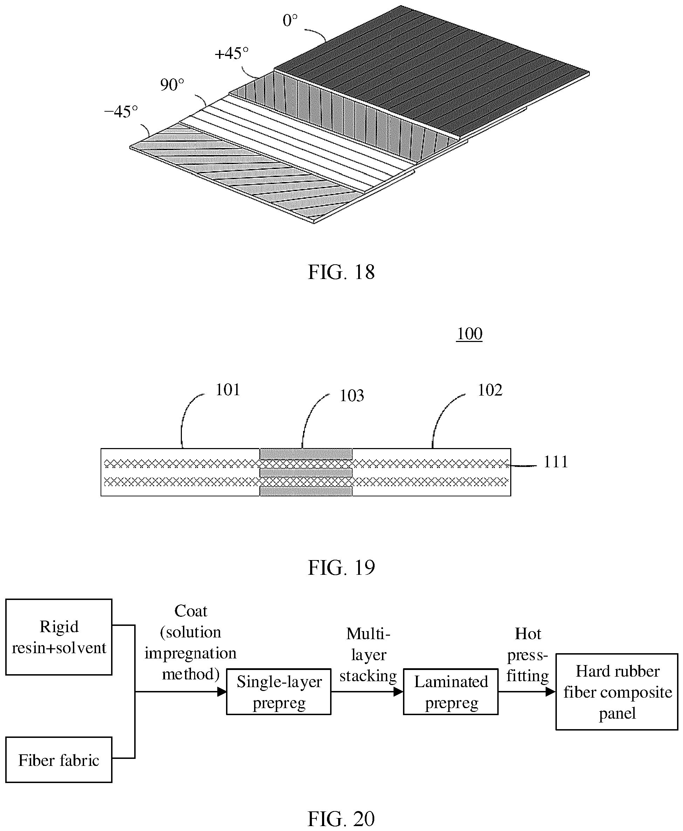

In an implementation of this application, the hard rubber fiber composite material may include only one fiber layer 111, or may include a plurality of (two or more) fiber layers 111. For example, there is one fiber layer 111 in the hard rubber fiber composite material in FIG. 14, and there are three fiber layers 111 in the hard rubber fiber composite material in FIG. 16 and FIG. 17. When there is one fiber layer 111, to meet a strength requirement, the fiber layer 111 is usually a multi-directional woven fiber layer. When there are a plurality of fiber layers 111, to better enhance mechanical strength of the hard rubber fiber composite material and improve strength of the hard rubber fiber composite material in all directions, the plurality of fiber layers 111 may be stacked at different angles (a plurality of angles), and each fiber layer 111 may be unidirectionally woven, or may be multi-directionally woven. In some embodiments, the plurality of fiber layers 111 may be a plurality of layers of unidirectional fiber fabric that are stacked at different angles, in other words, each fiber layer 111 is unidirectional fiber fabric. In an implementation of this application, a stacking direction of the plurality of fiber layers 111 may be any angle in a range of 0° to 90°. The plurality of fiber layers are stacked at different angles, so that fiber is distributed in a plurality of directions, and a fiber net is formed, to meet mechanical strength requirements of the hard rubber fiber composite material in different directions, and better provide rigid support for the flexible display. FIG. 18 is a schematic diagram of stacking of four layers of unidirectional fiber fabric at different angles. The four layers of unidirectional fiber fabric are respectively stacked at 0°, +45°, 90°, and -45°. In this way, fiber can be continuously distributed in a plurality of directions, strength of the hard rubber fiber composite material in the directions is improved, and overall mechanical performance of the hard rubber fiber composite material is improved. In this application, the 0° direction is the X direction in FIG. 2, in other words, a direction in which the first support member 101, the bendable connecting member 103, and the second support member 103 are arranged side by side. In some embodiments, when the plurality of fiber layers are stacked, to avoid warpage, the plurality of fiber layers may be stacked in a symmetrical manner from the middle to two sides in a stacking direction, for example, +45°/0°/0°/-45°, 0°/90°/0°/0°/90°/0°, 0°/+45°/-45°/-45°/+45°/0°, and 0°/90°/0°/90°/90°/0°/90°/0°.

In some implementations of this application, as shown in FIG. 16, the plurality of fiber layers 111 and the hard rubber material form a composite laminate in which fiber and hard rubber are alternately laminated. Fiber materials of the fiber layers 111 may be the same or different. Materials of the hard rubber layers may be the same, or may be different. Due to different preparation processes, for example, a solution impregnation method is used, two sides of each fiber layer 111 are usually impregnated with a hard rubber material. When a plurality of fiber layers are laminated, if different fiber layers are impregnated with different hard rubber materials, the hard rubber layer located in the middle of the laminate may include two different hard rubber materials. The different fiber layers are more conducive to forming a strong bonding force by selecting a same hard rubber material for impregnation. In some other implementations of this application, as shown in FIG. 17, the plurality of fiber layers 111 may be stacked together in contact, and then be impregnated with a hard rubber material, in other words, the hard rubber fiber composite material includes a fiber stack 11 formed by laminating the plurality of fiber layers, and a hard rubber material impregnated and cured on the fiber stack 11.

In an implementation of this application, a material of the bendable connecting member 103 may include one or more of a soft rubber fiber composite material, a bendable metal material, a bendable hard rubber fiber composite material, or an organic flexible material. The bendable connecting member 103 may have good bending performance by using the foregoing material, so that the first support member 101 and the second support member 102 can be folded or unfolded relative to each other.

In an implementation, the bendable connecting member 103 is a soft rubber fiber composite material, and is specifically a soft rubber fiber composite panel. Two sides of the soft rubber fiber composite panel are respectively connected to the first support member 101 and the second support member 102 that are formed by a hard rubber fiber composite panel. In this case, the substrate layer 100 is a composite panel structure of a hard rubber fiber composite material, a soft rubber fiber composite material, and a hard rubber fiber composite material in sequence. The soft rubber fiber composite material is used in a middle region to implement a flexible bending function, and the hard rubber fiber composite material is used on two sides to provide under-screen support for the flexible display. In an implementation of this application, the soft rubber fiber composite material includes at least one fiber layer, and a soft rubber material that is impregnated and cured on the fiber layer. In an implementation of this application, for fiber selection, a specific structure of the fiber layer, a structure of the soft rubber fiber composite material, a preparation manner, and the like in the soft rubber fiber composite material, refer to related descriptions of the hard rubber fiber composite material. Details are not described herein again. A difference between the soft rubber fiber composite material and the hard rubber fiber composite material in this application lies in that the soft rubber fiber composite material is a soft rubber material bonded to fiber, and the hard rubber fiber composite material is a hard rubber material bonded to fiber. The soft rubber fiber composite material is soft and bendable, and can be used as a bendable connecting member to match bending of the bending region of the flexible display. The hard rubber fiber composite material has high rigidity, and can effectively support the non-bending regions of the flexible display. The soft rubber material may include, but is not limited to, one or more of fluorine rubber, silicone rubber, and a thermoplastic elastomer. The thermoplastic elastomer, in other words, artificial rubber or synthetic rubber, may specifically include, but is not limited to, one or more of thermoplastic polyurethane (TPU), a thermoplastic polyester elastomer (TPEE), a styrene-based thermoplastic elastomer, a polyolefin-based thermoplastic elastomer (POE), a polyether ester-based thermoplastic elastomer, and a polyamide-based thermoplastic elastomer.

In an implementation of this application, a mass content of the fiber in the soft rubber fiber composite material is 10% to 80%. Specifically, the mass content of the fiber in the soft rubber fiber composite material may be, for example, 10%, 20%, 30%, 40%, 50%, 60%, 70%, or 80%. The fiber content in the soft rubber fiber composite material may be adjusted according to a specific bending performance requirement, a rigid support requirement, and performance of the selected soft rubber material. Generally, when the fiber content is higher, the overall strength of the soft rubber fiber composite material is increased, the bending property is reduced, and the weight is relatively reduced. In some implementations, in combination with bending performance, rigid support performance, and a weight reduction requirement, the mass content of the fiber in the soft rubber fiber composite material may be 10% to 50%.

In an implementation of this application, in the substrate layer 100, the fiber layer in the first support member 101 and the second support member 102 and the fiber layer in the bendable connecting member 103 may be designed to be independent of each other, or may be an integrally woven structure. Materials of the fiber layers may be the same or different. Quantities of layers of the fiber layers may be the same or different. Stacking manners of fiber layers may be the same or different. The fiber content may be the same or different. The fiber content in the hard rubber fiber composite material and the fiber content in the soft rubber fiber composite material may be selected according to specific conditions. Generally, the fiber content in the soft rubber fiber composite material is lower than the fiber content in the hard rubber fiber composite material.

In some implementations of this application, as shown in FIG. 19, when the bendable connecting member 103 is a soft rubber fiber composite material, the substrate layer 100 may be an integrally woven fiber layer 111 that continuously exists in the first support member 101, the second support member 102, and the bendable connecting member 103. The flexible display support structure 30 may be an integrally woven fiber layer including one or more layers. As shown in FIG. 19, two integrally woven fiber layers are included. The integrally woven fiber layer can simplify a preparation process, and ensure reliable connection among the first support member 101, the second support member 102, and the bendable connecting member 103.

In an implementation of this application, the soft rubber fiber composite material includes a plurality of fiber layers, the plurality of fiber layers and the soft rubber material may form a composite laminate in which the fiber and soft rubber are alternately laminated; or the plurality of fiber layers may be laminated to form a fiber stack, and the soft rubber material is impregnated and cured on the fiber stack.

In an implementation of this application, the bendable connecting member 103 may be formed by using single-layer woven fiber fabric, or may be formed by stacking a plurality of layers of unidirectional fiber fabric at a plurality of angles.

In an implementation of this application, a specific preparation manner of the substrate layer 100 that is formed by a hard rubber fiber composite material, a soft rubber fiber composite material, and a hard rubber fiber composite material in sequence is not limited. For example, the substrate layer 100 may be prepared in the following two manners:

### Manner 1:

Step 101: Take a plurality of fiber layers, and stack the plurality of fiber layers at a plurality of angles, to form a fiber stack.

The plurality of fiber layers are usually a plurality of layers of unidirectional fiber fabric, and the plurality of fiber layers may be stacked at any angle in a range from 0° to 90°.

Step 102: Impregnate a hard rubber material on two sides of the fiber stack by using a solvent impregnation method or a hot melting method, impregnate a soft rubber material in the middle, and obtain the substrate layer 100 after hot press-fitting. The substrate layer 100 prepared in this manner is an integrally woven fiber layer that continuously exists in the first support member 101, the second support member 102, and the bendable connecting member 103.

### Manner 2:

Step 201: Take a fiber layer, and impregnate a hard rubber material on two sides of the fiber layer by using a solvent impregnation method or a hot melting method, to form a hard rubber fiber single-layer prepreg; and perform multi-layer stacking on the hard rubber fiber single-layer prepreg at a plurality of angles, to obtain a hard rubber fiber laminated prepreg.

Step 202: Take a fiber layer, and impregnate a soft rubber material on two sides of the fiber layer by using a solvent impregnation method or a hot melting method to form a soft rubber fiber single-layer prepreg; and perform multi-layer stacking on the soft rubber fiber single-layer prepreg at a plurality of angles, and then perform hot press-fitting to obtain a soft rubber fiber composite panel. In this step, a single fiber layer of a target thickness may be directly selected, and multi-layer stacking is not used. The fiber layer on which a plurality of layers are stacked is usually unidirectional fiber fabric, and when a single fiber layer is directly selected, the fiber layer is usually woven fiber fabric.

Step 203: Arrange the hard rubber fiber laminated prepreg, the soft rubber fiber composite panel, and the hard rubber fiber laminated prepreg side by side, and then perform hot press-fitting to obtain the substrate layer 100.

In this implementation, the substrate layer 100 is a composite panel made of a hard rubber fiber composite material, a soft rubber fiber composite material, and a hard rubber fiber composite material in sequence. The substrate layer 100 has a flat plate or sheet structure as a whole.

To better bond the hard rubber fiber composite material and the soft rubber fiber composite material at a connection, when the two materials are arranged side by side, the hard rubber fiber laminated prepregs on the two sides may be partially cross-connected to the soft rubber fiber composite panel in the middle. Specifically, a width of a single-layer prepreg located in the middle several layers of the hard rubber fiber laminated prepreg may be reduced, in other words, the single-layer prepreg is indented to a specific width, to reserve a clamping space. The soft rubber fiber composite panel in the middle is partially clamped in the clamping space, and after the press-fitting, the composite panel made of the hard rubber fiber composite material, the soft rubber fiber composite material, and the hard rubber fiber composite material in sequence is prepared without a step difference. The hard rubber fiber laminated prepreg forms a hard rubber fiber composite panel, to be specific, the panel made of a hard rubber fiber composite material, after hot press-fitting.

In some other implementations of this application, multi-layer stacking may be performed on the soft rubber fiber single-layer prepregs at a plurality of angles to obtain the soft rubber fiber laminated prepreg, then the hard rubber fiber laminated prepreg, the soft rubber fiber laminated prepreg, and the hard rubber fiber laminated prepreg are arranged side by side, and then hot press-fitting is performed, to obtain the flexible display support structure. In some other implementations of this application, multi-layer stacking may be performed on the hard rubber fiber single-layer prepreg at a plurality of angles to obtain the hard rubber fiber laminated prepreg, then hot press-fitting is performed to obtain the hard rubber fiber composite panel, then the hard rubber fiber composite panel, the soft rubber fiber composite panel, and the hard rubber fiber composite panel are arranged side by side, and then hot press-fitting is performed, to obtain the flexible display support structure.

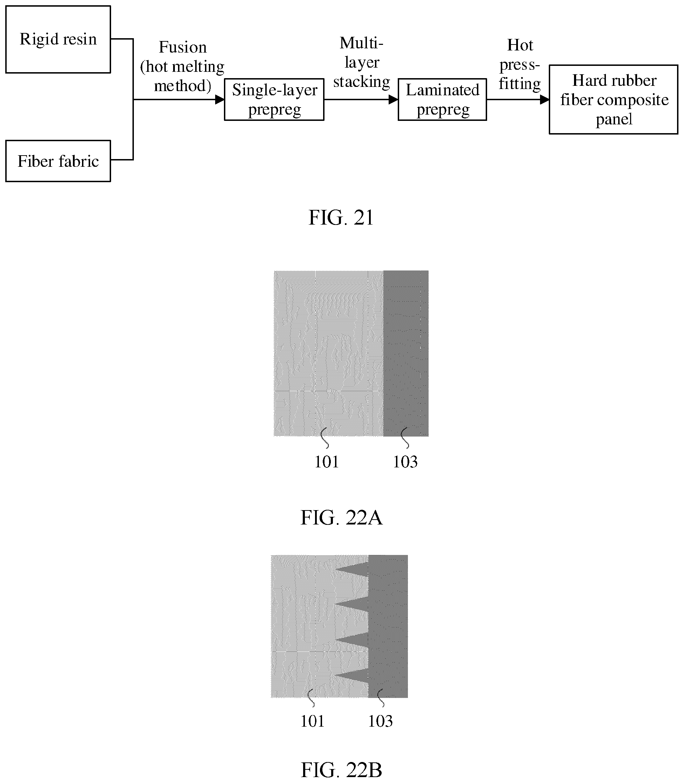

FIG. 20 is a flowchart of a preparation process of a hard rubber fiber composite material by using a solvent impregnation method. FIG. 21 is a flowchart of a preparation process of a hard rubber fiber composite material by using a hot melting method.

In an implementation of this application, the hard rubber fiber composite material and the soft rubber fiber composite material may be spliced and bonded in the foregoing hot press-fitting manner, or may be spliced and bonded in another manner that can implement good bonding, for example, gluing, fusion bonding, laser welding, or the like.

In another implementation of this application, the bendable connecting member 103 is a bendable metal connecting member, and two sides of the bendable metal connecting member are respectively connected to the first support member 101 and the second support member 102 that are formed by a hard rubber fiber composite panel. The bendable metal connecting member may be specifically made of a metal material such as a stainless steel, a titanium alloy, an aluminum alloy, or the like. The bendable metal connecting member 103 may be bonded to the first support member 101 and the second support member 102 in a manner of hot press-fitting, gluing, splicing, clamping, or the like, or may be connected by a connection mechanism.

In an implementation of this application, a specific preparation manner of the substrate layer 100 that is formed by a hard rubber fiber composite material, a metal material, and a hard rubber fiber composite material in sequence is not limited. For example, the substrate layer 100 may be prepared in the following manner:

Step 301: Take a fiber layer, and impregnate a hard rubber material on two sides of the fiber layer by using a solvent impregnation method or a hot melting method, to form a hard rubber fiber single-layer prepreg; and perform multi-layer stacking on the hard rubber fiber single-layer prepreg at a plurality of angles, to obtain a hard rubber fiber laminated prepreg.

Step 302: Take a metal sheet of a target thickness, arrange the hard rubber fiber laminated prepreg, the metal sheet, and the hard rubber fiber laminated prepreg side by side, and then perform hot press-fitting to obtain the substrate layer 100.

In this implementation, the substrate layer 100 is a composite panel made of a hard rubber fiber composite material, a metal material, and a hard rubber fiber composite material in sequence. The substrate layer 100 has a flat plate or sheet structure as a whole.

To better bond the hard rubber fiber composite material and the metal sheet at a connection, when the two materials are arranged side by side, the hard rubber fiber laminated prepregs on the two sides may be partially cross-connected to the metal sheet in the middle. Specifically, a width of a single-layer prepreg located in the middle several layers of the hard rubber fiber laminated prepreg may be reduced, in other words, the single-layer prepreg is indented to a specific width, to reserve a clamping space. Two ends of the metal sheet in the middle are reduced by a specific thickness, to form a clamping part (a step surface is formed due to a reduced surface) matching the clamping space, and the clamping part is clamped in the clamping space of the hard rubber fiber laminated prepreg. After the hot press-fitting, the composite panel made of the hard rubber fiber composite material, the metal material, and the hard rubber fiber composite material in sequence is prepared without a step difference. The clamping parts at both ends of the metal sheet may form an opening through etching, to enhance the bonding of the hard rubber fiber composite material and the metal sheet. Before the hot press-fitting, the surface of the metal sheet may be treated with plasma, to improve surface roughness and enhance the bonding between the hard rubber fiber composite material and the metal sheet.

In an implementation of this application, a metal sheet used as a bendable connecting member is required to have good bending performance, and is usually a porous metal sheet, and a porous hole extends vertically (in other words, in a Y direction).

In an implementation of this application, the hard rubber fiber composite material and the metal material may be spliced and bonded in the foregoing hot press-fitting manner, or may be spliced and bonded in another manner that can implement good bonding, for example, gluing, fusion bonding, laser welding, or the like.

In another implementation of this application, the bendable connecting member 103 is an organic flexible material film. Two sides of the organic flexible material film are respectively connected to the first support member 101 and the second support member 102 that are formed by the hard rubber fiber composite panel, and may be specifically bonded together through hot press-fitting, gluing, welding, or clamping, or may be connected by a connection mechanism. The organic flexible material film can implement a flexible and bending function. The organic flexible material may include one or more of fluorine rubber, silicone rubber, a thermoplastic elastomer, polyvinyl chloride (PVC), polyimide (PI), polyethylene terephthalate (PET), a cyclic olefin polymer (COP), a liquid crystal polymer (LCP), and polydimethylsiloxane (PDMS). The thermoplastic elastomer is, in other words, artificial rubber or synthetic rubber. The thermoplastic elastomer may specifically include one or more of thermoplastic polyurethane (TPU), a thermoplastic polyester elastomer (TPEE), a styrene-based thermoplastic elastomer, a polyolefin-based thermoplastic elastomer (POE), a polyether ester-based thermoplastic elastomer, and a polyamide-based thermoplastic elastomer.

In an implementation of this application, a specific preparation manner of the substrate layer 100 that is formed by a hard rubber fiber composite material, an organic flexible material, and a hard rubber fiber composite material in sequence is not limited. For example, the substrate layer 100 may be prepared in the following manner:

Step 301: Take a fiber layer, and impregnate a hard rubber material on two sides of the fiber layer by using a solvent impregnation method or a hot melting method, to form a hard rubber fiber single-layer prepreg; and perform multi-layer stacking on the hard rubber fiber single-layer prepreg at a plurality of angles, to obtain a hard rubber fiber laminated prepreg.

Step 302: Take an organic flexible material film of a target thickness, arrange the hard rubber fiber laminated prepreg, the organic flexible material film, and the hard rubber fiber laminated prepreg side by side, and then perform hot press-fitting to obtain the substrate layer 100.

In this implementation, the substrate layer 100 is a composite panel made of a hard rubber fiber composite material, an organic flexible material, and a hard rubber fiber composite material in sequence. The substrate layer 100 has a flat plate or sheet structure as a whole.

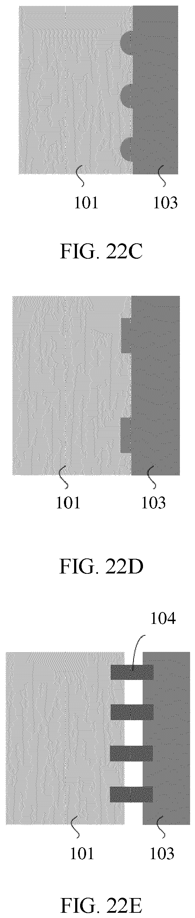

In this implementation, a structure of a joint between a hard rubber fiber composite panel 101 and an organic flexible material film 103 is not limited. The combination may be a combination of lines shown in FIG. 22A, or may be a combination of teeth shown in FIG. 22B, FIG. 22C, and FIG. 22D, in other words, clamping. Alternatively, as shown in FIG. 22E, a connection mechanism 104 is used to implement a connection between the two, for example, a combination of a buckle. A specific tooth shape of the tooth combination is not limited, and teeth may be formed on the hard rubber fiber composite panel 101, or may be formed on the organic flexible material film 103.

In another implementation of this application, the bendable connecting member 103 is a bendable hard rubber fiber composite material. To implement bending performance of the hard rubber fiber composite material in the region of the bendable connecting member 103, the hard rubber fiber composite material in the region of the bendable connecting member 103 may be formed into a porous structure in a manner such as laser hole-cutting. In other words, the bendable hard rubber fiber composite material is a hard rubber fiber composite material having the porous structure. To better obtain bending performance, the porous structure may be arranged in a longitudinal extension manner (in other words, in a Y direction in FIG. 3). The bendable connecting member 103 may be an integrally formed structure with the first support member 101 and/or the second support member 102. In some embodiments, the entire substrate layer 100 includes an entire hard rubber fiber composite panel that is integrally formed. The bendable connecting member 103 is made of a same material as the first support member 101 and the second support member 102. The substrate layer 100 includes a fiber layer and a hard rubber layer that are integrally woven and that continuously (in other words, continuously and without a connection interface) exist in the first support member 101, the second support member 102, and the bendable connecting member 103. When the bendable connecting member 103 is a bendable hard rubber fiber composite material, the substrate layer 100 is an integrally formed structure, which helps to implement high structural stability of the substrate layer as a whole.

In an implementation of this application, a specific preparation manner of the substrate layer 100 that is formed by a hard rubber fiber composite material, a bendable hard rubber fiber composite material, and a hard rubber fiber composite material in sequence is not limited. For example, the substrate layer 100 may be prepared in the following manner:

Step 401: Take a fiber layer, and impregnate a hard rubber material on two sides of the fiber layer by using a solvent impregnation method or a hot melting method, to form a hard rubber fiber single-layer prepreg; and perform multi-layer stacking on the hard rubber fiber single-layer prepreg at a plurality of angles, and then perform hot press-fitting to obtain a hard rubber fiber panel.

Step 402: Form a porous structure in a preset bendable connecting member region of the hard rubber fiber panel in a laser hole-cutting manner, so that the bendable connecting member region has bendable performance, to obtain the substrate layer 100.

In this implementation, the substrate layer 100 is a composite panel made of a hard rubber fiber composite material, a bendable hard rubber fiber composite material, and a hard rubber fiber composite material in sequence, and the substrate layer 100 is an integrally formed plate or sheet structure.

In an implementation of this application, a thickness of the substrate layer 100 may be approximately 0.1 mm to 5 mm. Specifically, the foldable terminal may be designed according to an actual requirement of the foldable terminal. When the thickness is larger, it indicates that support strength is larger. In some implementations, the thickness of the substrate layer 100 may be 0.15 mm to 0.2 mm. In some other implementations, the thickness of the substrate layer 100 may be 0.25 mm to 0.8 mm. In some other implementations, the thickness of the substrate layer 100 may be 1 mm to 2 mm, or may be 2 mm to 4 mm. A small thickness of the substrate layer 100 helps reduce a weight, and also helps reduce a total thickness of the foldable terminal, to improve user experience.

In an implementation of this application, a thickness of the flexible display support structure 30 may be 0.1 mm to 5 mm. In some implementations, the thickness of the flexible display support structure 30 may be 0.15 mm to 0.22 mm. In some other implementations, the thickness of the flexible display support structure 30 may be 0.25 mm to 0.8 mm. In some other implementations, the thickness of the flexible display support structure 30 may be 1 mm to 2 mm, or may be 2.5 mm to 4 mm. A total thickness of the flexible display support structure 30 mainly depends on a sum of the thicknesses of the substrate layer 100 and the functional layer 200.

In this application, "a plurality of types of" indicates two or more types. In this application, "-" represents a range value, including endpoint values at two ends. For example, if the thickness of the functional layer 200 is 5 µm to 500 µm, it indicates that the thickness of the functional layer 200 is between 5 µm and 500 µm, and includes endpoint values 5 µm and 500 µm.

Embodiments of this application are further described below by using a plurality of embodiments.

### Embodiment 1

Refer to FIG. 6B. A flexible display support structure 30 in this embodiment includes a substrate layer 100 and electrically conductive layers 200 disposed on two sides of the substrate layer 100. The electrically conductive layers 200 cover surfaces of a first support member and a second support member of the substrate layer 100, and do not cover a bendable connecting member. The substrate layer 100 uses an epoxy resin continuous carbon fiber-polyurethane (TPU) continuous carbon fiber-epoxy resin continuous carbon fiber composite panel. A foldable mobile phone of a model is used as an example. In a design solution of the flexible display support structure in this embodiment, an external dimension of the flexible display support structure is 161 mm* 146 mm, a thickness of the substrate layer is 0.15 mm, a width of a flexible bendable region, that is, the bendable connecting member, is 20 mm, and widths of support members on two sides are 63 mm. Three panels, to be specific, an epoxy resin continuous carbon fiber composite panel, a polyurethane continuous carbon fiber composite panel, and an epoxy resin continuous carbon fiber composite panel are arranged and combined side by side in sequence to form the substrate layer. The electrically conductive layers 200 are nickel layers.

A preparation process of the flexible display support structure in this embodiment is as follows:
(1) A carbon unidirectional fiber fabric with a thickness of 0.02 mm is selected, and surfaces of two sides are immersed in epoxy resin to obtain a single-layer prepreg with a thickness of 0.025 mm, and then prepregs are laminated according to a 0°/90°/0°/0°/90°/0° stacking angle to form an epoxy resin carbon fiber laminated prepreg with a thickness of 0.15 mm.
(2) 45° woven carbon fiber fabric with a thickness of 0.1 mm and a width of 30 mm is immersed in TPU to form a 0.15-mm thick TPU continuous carbon fiber composite panel.
(3) The three materials, to be specific, the epoxy resin continuous carbon fiber laminated prepreg, the polyurethane continuous carbon fiber composite panel, and the epoxy resin continuous carbon fiber laminated prepreg, are arranged side by side in sequence, and the polyurethane continuous carbon fiber composite panel and the epoxy resin continuous carbon fiber laminated prepregs on two sides are cross-connected. A temperature of a hot press is raised to 150°C, a mold gap is 0.15 mm, and press-fitting is performed for 30 minutes at 150°C to obtain an epoxy resin continuous carbon fiber-polyurethane (TPU) continuous carbon fiber-epoxy resin continuous carbon fiber composite panel with a thickness of 0.15 mm.
(4) Edge cutting is performed on the composite panel obtained in step (3), and the composite panel is cut into required dimensions to obtain the substrate layer.
(5) The bendable region of the substrate layer is covered, and acid cleaning is performed on the support member panels on two sides of the bendable region to remove surface oil stain.
(6) The surfaces of the two sides of the support members are catalyzed, and a layer of catalyst containing palladium is deposited on the surfaces of the support members.
(7) The substrate layer is immersed in a plating solution to perform chemical nickel plating, and a time is 4 h to 12 h. A nickel layer of 5 µm to 10 µm is deposited on the surfaces of the support members, and the nickel layer is washed and dried to obtain the flexible display support structure.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, and no cracking occurs. In addition, in a bending process, the carbon fiber in a bending region may be stretched and deformed. This is because the bending region is a 45° woven carbon fiber. Therefore, deformation may occur in the bending process, and a displacement difference between a folded state and an unfolded state is absorbed. The flexible display support structure prepared in this embodiment has an electrical conduction function, and can meet an electrical connection requirement.

### Embodiment 2

Refer to FIG. 6B. A flexible display support structure 30 in this embodiment includes a substrate layer 100 and electrically conductive layers 200 disposed on two sides of the substrate layer 100. The electrically conductive layers 200 cover surfaces of a first support member and a second support member of the substrate layer 100, and do not cover a bendable connecting member. The substrate layer 100 uses an epoxy resin continuous carbon fiber-TPU continuous carbon fiber-epoxy resin continuous carbon fiber composite panel. A foldable mobile phone of a model is used as an example. In a design solution of the flexible display support structure in this embodiment, an external dimension of the flexible display support structure is 161 mm* 146 mm, a thickness of the substrate layer is 0.15 mm, a width of a flexible bendable region, that is, the bendable connecting member, is 20 mm, and widths of support members on two sides are 63 mm. Three panels, to be specific, an epoxy resin continuous carbon fiber composite panel, a TPU continuous carbon fiber composite panel, and an epoxy resin continuous carbon fiber composite panel are arranged and bonded side by side in sequence to form the substrate layer. Each electrically conductive layer 200 includes a copper layer and a nickel layer that are disposed on the substrate layer 100 in sequence.

A preparation process of the flexible display support structure in this embodiment is as follows:
(1) A carbon unidirectional fiber fabric with a thickness of 0.02 mm is selected, and surfaces of two sides are immersed in epoxy resin to obtain a single-layer prepreg with a thickness of 0.025 mm, and then prepregs are laminated according to a 0°/90°/0°/0°/90°/0° stacking angle to form an epoxy resin carbon fiber laminated prepreg with a thickness of 0.15 mm.
(2) 0°/90° woven carbon fiber fabric with a thickness of 0.1 mm and a width of 30 mm is immersed in TPU to form a 0.15-mm thick TPU continuous carbon fiber composite panel.
(3) The three panels, to be specific, the epoxy resin continuous carbon fiber laminated prepreg, the TPU continuous carbon fiber composite panel, and the epoxy resin continuous carbon fiber laminated prepreg, are arranged side by side in sequence, and the polyurethane continuous carbon fiber composite panel and the epoxy resin continuous carbon fiber laminated prepregs on two sides are cross-connected. A temperature of a hot press is raised to 150°C, a mold gap is 0.15 mm, and press-fitting is performed for 30 minutes at 150°C to obtain an epoxy resin continuous carbon fiber-TPU continuous carbon fiber-epoxy resin continuous carbon fiber composite panel with a thickness of 0.15 mm.
(4) Edge cutting is performed on the composite panel obtained in step (3), and the composite panel is cut into required dimensions to obtain the substrate layer.
(5) The bendable region of the substrate layer is covered, and acid cleaning is performed on the support member panels on two sides of the bendable region to remove surface oil stain.
(6) The surfaces of the two sides of the support members are catalyzed, and a layer of catalyst containing palladium is deposited on the surfaces of the support members.
(7) The substrate layer is immersed in a first plating solution for chemical copper plating for a period of 4 to 12 hours. A copper layer of 5 µm to 10 µm is deposited on the surfaces of the support members. After being washed, the substrate layer is immersed in a second plating solution for chemical nickel plating for a period of 4 to 12 hours. A nickel layer of 2 µm to 10 µm is deposited, and the nickel layer is washed and dried to obtain the flexible display support structure.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, no cracking occurs, and good flatness can still be maintained after testing. Compared with Embodiment 1, the bending region of the flexible display support structure in this embodiment has continuous carbon fiber in a 0° direction, and therefore it is relatively difficult to absorb a displacement difference between unfolding and bending. Compared with Embodiment 1, in this embodiment, a copper layer is added to the electrically conductive layer, and conductivity of copper is better than that of the nickel. Therefore, conductivity of the flexible display support structure in this embodiment is better than that in Embodiment 1.

### Embodiment 3

Refer to FIG. 5. A flexible display support structure 30 in this embodiment includes a substrate layer 100 and an impact-resistant layer 200 disposed on one side of the substrate layer 100. The substrate layer 100 uses an epoxy resin continuous carbon fiber-polyimide (PI)-epoxy resin continuous carbon fiber composite panel. A foldable mobile phone of a model is used as an example. In a design solution of the flexible display support structure in this embodiment, an external dimension of the flexible display support structure is 161 mm* 146 mm, a thickness of the substrate layer is 0.15 mm, a width of a flexible bendable region, that is, the bendable connecting member, is 20 mm, and widths of support members on two sides are 63 mm. Three panels, to be specific, an epoxy resin continuous carbon fiber composite panel, a PI film, and an epoxy resin continuous carbon fiber composite panel are arranged and combined side by side in sequence to form the flexible display support structure. The impact-resistant layer 200 is a TPU thin film.

A preparation process of the flexible display support structure in this embodiment is as follows:
(1) A carbon unidirectional fiber fabric with a thickness of 0.03 mm is selected, and surfaces of two sides are immersed in epoxy resin to obtain a single-layer prepreg with a thickness of 0.05 mm, and then prepregs are laminated according to a 0°/90°/0° stacking angle to form an epoxy resin carbon fiber laminated prepreg with a thickness of 0.15 mm.
(2) API film with a width of 25 mm and a thickness of 0.15 mm is prepared.
(3) The epoxy resin carbon fiber laminated prepreg, the PI film, and the epoxy resin carbon fiber laminated prepreg are arranged side by side, and the PI film and the epoxy resin carbon fiber laminated prepregs are staggered by 2 mm to 5 mm.
(4) A temperature of a hot press is raised to 200°C, and a mold gap is 0.15 mm. Press-fitting is performed at 200°C for 20 minutes to obtain an epoxy resin continuous carbon fiber-PI film-epoxy resin continuous carbon fiber composite panel with a thickness of 0.15 mm.
(5) Edge cutting is performed on the composite panel obtained in step (4), and the composite panel is cut into required dimensions to obtain the substrate layer.
(6) A TPU thin film with a thickness of 50 µm to 150 µm is coated on one side of the substrate layer.
(7) The substrate layer and the TPU thin film are laminated, and placed in the hot press. Press-fitting is performed at a temperature of 150°C for 30 minutes. After cooling, the flexible display support structure is obtained.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, no cracking occurs, and good flatness can still be maintained after testing. In the flexible display support structure in this embodiment, because the bending region is made of a pure PI material and has no fiber, the flexible display support structure has better bending performance than a soft rubber fiber composite material, but lacks a fiber net and has a slightly weak support strength. The flexible display support structure prepared in this embodiment has an impact resistance function, and can effectively protect a flexible display from drop impact.

### Embodiment 4

Refer to FIG. 6A. A flexible display support structure 30 in this embodiment includes a substrate layer 100 and thermally conductive layers 200 disposed on two sides of the substrate layer 100. The substrate layer 100 uses a phenolic resin continuous glass fiber-TPU continuous glass fiber-phenolic resin continuous glass fiber composite panel. A foldable mobile phone of a model is used as an example. In a design solution of the flexible display support structure in this embodiment, an external dimension of the flexible display support structure is 161 mm* 146 mm, a thickness of the substrate layer is 0.2 mm, a width of a flexible bendable region, that is, the bendable connecting member, is 20 mm, and widths of support members on two sides are 63 mm. Three panels, to be specific, a phenolic resin continuous glass fiber composite panel, a TPU continuous glass fiber composite panel, and a phenolic resin continuous glass fiber composite panel are arranged and combined side by side in sequence to form the substrate layer. A material of the thermally conductive layer 200 is a thermally conductive graphite sheet.

A preparation process of the flexible display support structure in this embodiment is as follows:
(1) A glass unidirectional fiber fabric with a thickness of 0.02 mm is selected, and surfaces of two sides are immersed in phenolic resin to obtain a single-layer prepreg with a thickness of 0.025 mm, and then prepregs are laminated according to a 0°/90°/0°/90°/90°/0°/90°/0° stacking angle to form a phenolic resin glass fiber laminated prepreg with a thickness of 0.2 mm.
(2) 45° woven glass fiber fabric with a thickness of 0.15 mm and a width of 30 mm is immersed in TPU to form a 0.2-mm thick TPU continuous glass fiber composite panel.
(3) Three panels, to be specific, a phenolic resin continuous glass fiber laminated prepreg, a polyurethane continuous glass fiber composite panel, and a phenolic resin continuous glass fiber laminated prepreg, are arranged side by side in sequence, and the polyurethane continuous glass fiber composite panel and the phenolic resin continuous glass fiber laminated prepregs are cross-connected on two sides. A temperature of a hot press is raised to 150°C, a mold gap is 0.2 mm, and press-fitting is performed for 30 minutes at 150°C to obtain a phenolic resin continuous glass fiber-TPU continuous glass fiber-phenolic resin continuous glass fiber composite panel with a thickness of 0.2 mm.
(4) Edge cutting is performed on the composite panel obtained in step (3), and the composite panel is cut into required dimensions to obtain the substrate layer.
(5) Two graphite sheets with a thickness of 30 µm to 100 µm are bonded to two sides of the substrate layer by a double-sided tape with a thickness of 10 µm to 20 µm, to obtain the flexible display support structure.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, no cracking occurs, and good flatness can still be maintained after testing. The flexible display support structure prepared in this embodiment has a thermal conduction function, and is conducive to transferring heat generated by a battery inside a terminal to a side of a flexible display.

### Embodiment 5

Refer to FIG. 8B. A flexible display support structure 30 in this embodiment includes a substrate layer 100 and an electrically conductive layer 201 and an impact-resistant layer 202 that are disposed on two sides of the substrate layer 100. The substrate layer 100 uses an epoxy resin continuous glass fiber-silicone rubber continuous glass fiber-epoxy resin continuous glass fiber composite panel. A foldable mobile phone of a model is used as an example. In a design solution of the flexible display support structure in this embodiment, an external dimension of the flexible display support structure is 161 mm* 146 mm, a thickness of the substrate layer is 0.2 mm, a width of a flexible bendable region, that is, the bendable connecting member, is 20 mm, and widths of support members on two sides are 63 mm. Three panels, to be specific, an epoxy resin continuous glass fiber composite panel, a silicone rubber continuous glass fiber composite panel, and an epoxy resin continuous glass fiber composite panel are arranged and combined side by side in sequence to form the substrate layer. A material of the electrically conductive layer 201 includes nickel and gold. A material of the impact-resistant layer 202 includes a TPU thin film.

A preparation process of the flexible display support structure in this embodiment is as follows:
(1) A glass unidirectional fiber fabric with a thickness of 0.02 mm is selected, and surfaces of two sides are immersed in epoxy resin to obtain a single-layer prepreg with a thickness of 0.025 mm, and then prepregs are laminated according to a 0°/90°/0°/90°/90°/0°/90°/0° stacking angle to form an epoxy resin glass fiber laminated prepreg with a thickness of 0.2 mm.
(2) 45° woven glass fiber fabric with a thickness of 0.15 mm and a width of 30 mm is immersed in silicone rubber to form a 0.2-mm thick silicone rubber continuous glass fiber composite panel.
(3) Three panels, to be specific, an epoxy resin continuous glass fiber laminated prepreg, a silicone rubber continuous glass fiber composite panel, and an epoxy resin continuous glass fiber laminated prepreg, are arranged side by side in sequence, and the silicone rubber continuous glass fiber composite panel and the epoxy resin continuous glass fiber laminated prepregs are cross-connected on two sides. A temperature of a hot press is raised to 150°C, a mold gap is 0.2 mm, and press-fitting is performed for 30 minutes at 150°C to obtain an epoxy resin continuous glass fiber-silicone rubber continuous glass fiber-epoxy resin continuous glass fiber composite panel with a thickness of 0.2 mm.
(4) Edge cutting is performed on the composite panel obtained in step (3), and the composite panel is cut into required dimensions to obtain the substrate layer.
(5) The bendable region of the substrate layer is covered, and acid cleaning is performed on the support member panels on two sides of the bendable region to remove surface oil stain.
(6) The surfaces of the two sides of the support members are catalyzed, and a layer of catalyst containing palladium is deposited on the surfaces of the support members.
(7) The substrate layer is immersed in a plating solution to perform chemical nickel plating for a period of 4 to 12 hours. A nickel layer of 5 µm to 10 µm is deposited on the surfaces of the support members, and the nickel layer is washed and dried.
(8) Then the nickel layer outside a pre-gold plating region is covered and immersed in the plating solution to perform chemical gold plating for 2 to 4 hours, so that a gold layer with a thickness of 1 µm to 2 µm is deposited in the pre-gold plating region, and the gold layer is washed and dried to form the electrically conductive layer.
(9) A TPU thin film with a thickness of 50 µm to 150 µm is separately coated on the two electrically conductive layers, and the electrically conductive layers are placed in a hot press. Press-fitting is performed at a temperature of 150°C for 30 minutes. After cooling, the flexible display support structure is obtained.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, no cracking occurs, and good flatness can still be maintained after testing. The flexible display support structure prepared in this embodiment has both an electrical conduction function and an impact resistance function.

### Embodiment 6

Refer to FIG. 8B. A flexible display support structure 30 in this embodiment includes a substrate layer 100 and an electrically conductive layer 201 and a thermally conductive layer 202 that are disposed on two sides of the substrate layer 100. The substrate layer 100 uses a phenolic resin continuous glass fiber-silicone rubber continuous glass fiber-phenolic resin continuous glass fiber composite panel. A foldable mobile phone of a model is used as an example. In a design solution of the flexible display support structure in this embodiment, an external dimension of the flexible display support structure is 161 mm* 146 mm, a thickness of the substrate layer is 0.2 mm, a width of a flexible bendable region, that is, the bendable connecting member, is 20 mm, and widths of support members on two sides are 63 mm. Three panels, to be specific, a phenolic resin continuous glass fiber composite panel, a silicone rubber continuous glass fiber composite panel, and a phenolic resin continuous glass fiber composite panel are arranged and combined side by side in sequence to form the substrate layer. A material of the electrically conductive layer 201 includes nickel and gold. A material of the thermally conductive layer 202 is a thermally conductive silicone sheet.

A preparation process of the flexible display support structure in this embodiment is as follows:
(1) A glass unidirectional fiber fabric with a thickness of 0.02 mm is selected, and surfaces of two sides are immersed in phenolic resin to obtain a single-layer prepreg with a thickness of 0.025 mm, and then prepregs are laminated according to a 0°/-45°/+45°/0°/0°/+45°/- 45°/0° stacking angle to form a phenolic resin glass fiber laminated prepreg with a thickness of 0.2 mm.
(2) 45° woven glass fiber fabric with a thickness of 0.15 mm and a width of 30 mm is immersed in silicone rubber to form a 0.2-mm thick TPU continuous glass fiber composite panel.
(3) Three panels, to be specific, a phenolic resin continuous glass fiber laminated prepreg, a silicone rubber continuous glass fiber composite panel, and a phenolic resin continuous glass fiber laminated prepreg, are arranged side by side in sequence, and the silicone rubber continuous glass fiber composite panel and the phenolic resin continuous glass fiber laminated prepregs are cross-connected on two sides. A temperature of a hot press is raised to 150°C, a mold gap is 0.2 mm, and press-fitting is performed for 30 minutes at 150°C to obtain a phenolic resin continuous glass fiber-silicone rubber continuous glass fiber-phenolic resin continuous glass fiber composite panel with a thickness of 0.2 mm.
(4) Edge cutting is performed on the composite panel obtained in step (3), and the composite panel is cut into required dimensions to obtain the substrate layer.
(5) The bendable region of the substrate layer is covered, and acid cleaning is performed on the support member panels on two sides of the bendable region to remove surface oil stain.
(6) The surfaces of the two sides of the support members are catalyzed, and a layer of catalyst containing palladium is deposited on the surfaces of the support members.
(7) The substrate layer is immersed in a plating solution to perform chemical nickel plating for a period of 4 to 12 hours. A nickel layer of 5 µm to 10 µm is deposited on the surfaces of the support members, and the nickel layer is washed and dried.
(8) Then the nickel layer outside a pre-gold plating region is covered and immersed in the plating solution to perform chemical gold plating for 2 to 4 hours, so that a gold layer with a thickness of 1 µm to 2 µm is deposited in the pre-gold plating region, and the gold layer is washed and dried to form the electrically conductive layer.
(9) A thermally conductive silicone sheet with a thickness of 30 µm to 100 µm is separately coated on the two electrically conductive layers, and the electrically conductive layers are placed in a hot press. Press-fitting is performed at a temperature of 100°C for 30 minutes. After cooling, the flexible display support structure is obtained.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, no cracking occurs, and good flatness can still be maintained after testing. The flexible display support structure prepared in this embodiment has both an electrical conduction function and a thermal conduction function.

### Embodiment 7

Refer to FIG. 8A. A flexible display support structure 30 in this embodiment includes a substrate layer 100 and a thermally conductive layer 201 and an impact-resistant layer 202 that are disposed on two sides of the substrate layer 100. The substrate layer 100 uses an epoxy resin continuous aramid fiber-polyurethane (TPU) continuous aramid fiber-epoxy resin continuous aramid fiber composite panel. A foldable mobile phone of a model is used as an example. In a design solution of the flexible display support structure in this embodiment, an external dimension of the flexible display support structure is 161 mm* 146 mm, a thickness of the substrate layer is 0.15 mm, a width of a flexible bendable region, that is, the bendable connecting member, is 20 mm, and widths of support members on two sides are 63 mm. Three panels, to be specific, an epoxy resin continuous aramid fiber composite panel, a polyurethane continuous aramid fiber composite panel, and an epoxy resin continuous aramid fiber composite panel are arranged and combined side by side in sequence to form the substrate layer. A material of the thermally conductive layer 201 is thermally conductive silicone. A material of the impact-resistant layer 202 is a TPU thin film.

A preparation process of the flexible display support structure in this embodiment is as follows:
(1) An aramid unidirectional fiber fabric with a thickness of 0.02 mm is selected, and surfaces of two sides are immersed in epoxy resin to obtain a single-layer prepreg with a thickness of 0.025 mm, and then prepregs are laminated according to a 0°/+45°/-45°/-45°/+45°/0° stacking angle to form an epoxy resin aramid fiber laminated prepreg with a thickness of 0.15 mm.
(2) 45° woven aramid fiber fabric with a thickness of 0.1 mm and a width of 30 mm is immersed in TPU to form a 0.15-mm thick TPU continuous aramid fiber composite panel.
(3) The three panels, to be specific, the epoxy resin continuous aramid fiber laminated prepreg, the polyurethane continuous aramid fiber composite panel, and the epoxy resin continuous aramid fiber laminated prepreg, are arranged side by side in sequence, and the polyurethane continuous aramid fiber composite panel and the epoxy resin continuous aramid fiber laminated prepregs on two sides are cross-connected. A temperature of a hot press is raised to 150°C, a mold gap is 0.15 mm, and press-fitting is performed for 30 minutes at 150°C to obtain an epoxy resin continuous aramid fiber-polyurethane (TPU) continuous aramid fiber-epoxy resin continuous aramid fiber composite panel with a thickness of 0.15 mm.
(4) Edge cutting is performed on the composite panel obtained in step (3), and the composite panel is cut into required dimensions to obtain the substrate layer.
(5) A thermally conductive silicone sheet with a thickness of 30 µm to 100 µm is separately coated on upper and lower sides of the substrate layer, and the substrate layer is placed in a hot press. Press-fitting is performed at a temperature of 100°C for 30 minutes, to form the thermally conductive layers.
(6) A TPU thin film with a thickness of 50 µm to 150 µm is separately coated on the two thermally conductive layers, and the thermally conductive layers are placed in a hot press. Press-fitting is performed at a temperature of 150°C for 30 minutes. After cooling, the flexible display support structure is obtained.

Compared with a flexible display support structure that is completely made of a stainless steel and that has a same size, a weight of the flexible display support structure prepared in this embodiment is reduced by more than 75%. In addition, the flexible display support structure prepared in this embodiment is bent 200,000 times for testing, no cracking occurs, and good flatness can still be maintained after testing. The flexible display support structure prepared in this embodiment has both a thermal conduction function and an impact resistance function.

### Embodiment 8

Refer to FIG. 11A. A flexible display support structure 30 in this embodiment includes a substrate layer 100 and functional layers 200 disposed on two sides of the substrate layer 100. The functional layer 200 on one side includes an electrically conductive layer 201 and an impact-resistant layer 202, and the functional layer 200 on the other side includes an electrically conductive layer. The substrate layer 100 uses the flexible display support structure in this embodiment as an epoxy resin continuous carbon fiber-stainless steel-epoxy resin continuous carbon fiber composite panel. A foldable mobile phone of a model is used as an example. In a design solution of the flexible display support structure in this embodiment, an external dimension of the flexible display support structure is 161 mm* 146 mm, a thickness of the flexible display support structure is 0.15 mm, a width of a flexible bendable region, that is, the bendable connecting member, is 20 mm, and widths of support members on two sides are 63 mm. Three panels, to be specific, an epoxy resin continuous carbon fiber composite panel, a stainless steel sheet, and an epoxy resin continuous carbon fiber composite panel are arranged and combined side by side in sequence, and two sides of the stainless steel sheet are respectively clamped in the epoxy resin continuous carbon fiber composite panel structures on the two sides to form the substrate layer. The electrically conductive layer is a nickel layer, and a material of the impact-resistant layer is a TPU thin film.

A preparation process of the flexible display support structure in this embodiment is as follows:
(1) A carbon unidirectional fiber fabric with a thickness of 0.02 mm is selected, and surfaces of two sides are immersed in epoxy resin to obtain a single-layer prepreg with a thickness of 0.025 mm, and then the single-layer prepregs are laminated according to a 0°/90°/0°/0°/90°/0° stacking angle to form an epoxy resin carbon fiber laminated prepreg with a thickness of 0.15 mm.
(2) A porous stainless steel sheet with a width of 30 mm and a thickness of 0.15 mm is prepared. A middle porous region (used as a flexible bendable region) is 20 mm. The left and right sides are lowered to form a step structure with a thickness of 0.05 mm and a width of 5 mm as a clamping part (a hole can be drilled in the clamping part).
(3) The epoxy resin carbon fiber laminated prepreg, the porous stainless steel sheet, and the epoxy resin carbon fiber laminated prepreg are arranged side by side in sequence. Each of the two sides of the porous stainless steel sheet and the epoxy resin carbon fiber laminated prepreg has a bonding region with a width of 5 mm. A temperature of a hot press is raised to 150°C, a mold gap is 0.15 mm, and press-fitting is performed for 30 minutes at 150°C to obtain an epoxy resin continuous carbon fiber-stainless steel-epoxy resin continuous carbon fiber composite panel with a thickness of 0.15 mm.
(4) Edge cutting is performed on the composite panel obtained in step (3), and the composite panel is cut into required dimensions to obtain the substrate layer.
(5) Acid cleaning is performed on the substrate layer to remove surface oil stain.
(6) Catalysis is performed on surfaces of two sides of the substrate layer, and a layer of catalyst containing palladium is deposited on the surfaces of the substrate layer.
(7) The substrate layer is immersed in a plating solution to perform chemical nickel plating for a period of 4 to 12 hours. A nickel layer of 5 µm to 10 µm is deposited, and the nickel layer is washed and dried, to form the electrically conductive layer.
(8) A TPU thin film with a thickness of 50 µm to 150 µm is coated on an electrically conductive layer on one side, and the electrically conductive layers are placed in a hot press. Press-fitting is performed at a temperature of 150°C for 30 minutes. After cooling, the flexible display support structure is obtained.

Compared with a flexible display support structure that is completely made of a stainless steel and that has a same size, a weight of the flexible display support structure prepared in this embodiment is reduced by more than 62%. In addition, the flexible display support structure prepared in this embodiment is bent 200,000 times for testing, no cracking occurs, and good flatness can still be maintained after testing. The flexible display support structure prepared in this embodiment has both an electrical conduction function and an impact resistance function.

### Embodiment 9

Refer to FIG. 10. A flexible display support structure 30 in this embodiment includes a substrate layer 100 and an electrically conductive layer 201, a thermally conductive layer 202, and an impact-resistant layer 203 that are disposed on two sides of the substrate layer 100. The substrate layer 100 uses an epoxy resin continuous glass fiber-titanium alloy-epoxy resin continuous glass fiber composite panel. A foldable mobile phone of a model is used as an example. In a design solution of the flexible display support structure in this embodiment, an external dimension of the flexible display support structure is 161 mm* 146 mm, a thickness of the substrate layer is 0.15 mm, a width of a flexible bendable region, that is, the bendable connecting member, is 20 mm, and widths of support members on two sides are 63 mm. Three panels, to be specific, an epoxy resin continuous carbon fiber composite panel, a titanium alloy, and an epoxy resin continuous carbon fiber composite panel are arranged and combined side by side in sequence, and two sides of the titanium alloy sheet are respectively clamped in the epoxy resin continuous carbon fiber composite panel structures on the two sides to form the substrate layer. The electrically conductive layer is a nickel layer, the thermally conductive layer includes a thermally conductive double-sided tape, and a material of the impact-resistant layer is a TPEE thin film.

A preparation process of the flexible display support structure in this embodiment is as follows:
(1) A carbon unidirectional fiber fabric with a thickness of 0.02 mm is selected, and surfaces of two sides are immersed in epoxy resin to obtain a single-layer prepreg with a thickness of 0.025 mm, and then the single-layer prepregs are laminated according to a 0°/90°/0°/0°/90°/0° stacking angle to form an epoxy resin carbon fiber laminated prepreg with a thickness of 0.15 mm.
(2) A porous titanium alloy sheet with a width of 30 mm and a thickness of 0.15 mm is prepared. A middle porous region (used as a flexible bendable region) is 20 mm. The left and right sides are lowered to form a step structure with a thickness of 0.05 mm and a width of 5 mm as a clamping part (a hole can be drilled in the clamping part).
(3) The epoxy resin carbon fiber laminated prepreg, the porous titanium alloy sheet, and the epoxy resin carbon fiber laminated prepreg are arranged side by side in sequence. Each of the two sides of the porous titanium alloy sheet and the epoxy resin carbon fiber laminated prepreg has a bonding region with a width of 5 mm. A temperature of a hot press is raised to 150°C, a mold gap is 0.15 mm, and press-fitting is performed for 30 minutes at 150°C to obtain an epoxy resin continuous carbon fiber-titanium alloy-epoxy resin continuous carbon fiber composite panel with a thickness of 0.15 mm.
(4) Edge cutting is performed on the composite panel obtained in step (3), and the composite panel is cut into required dimensions to obtain the substrate layer.
(5) Acid cleaning is performed on the substrate layer to remove surface oil stain.
(6) Catalysis is performed on surfaces of two sides of the substrate layer, and a layer of catalyst containing palladium is deposited on the surfaces of the substrate layer.
(7) The substrate layer is immersed in a plating solution to perform chemical nickel plating for a period of 4 to 12 hours. A nickel layer of 5 µm to 10 µm is deposited, and the nickel layer is washed and dried, to form the electrically conductive layer.
(8) An electrically conductive double-sided tape with a thickness of 30 µm to 100 µm is bonded to the electrically conductive layers on the two sides, and then a layer of TPEE thin film with a thickness of 50 µm to 150 µm is bonded to the other side of the tape, to obtain the flexible display support structure.

Compared with a flexible display support structure that is completely made of a stainless steel and that has a same size, a weight of the flexible display support structure prepared in this embodiment is reduced by more than 70%. In addition, the flexible display support structure prepared in this embodiment is bent 200,000 times for testing, no cracking occurs, and good flatness can still be maintained after testing. The flexible display support structure prepared in this embodiment has both an electrical conduction function, a thermal conduction function, and an impact resistance function.

### Embodiment 10

Refer to FIG. 11B. A flexible display support structure 30 in this embodiment includes a substrate layer 100 and functional layers 200 disposed on two sides of the substrate layer 100. The functional layer 200 on one side includes an electrically conductive layer 201 and an impact-resistant layer 202, and the functional layer 200 on the other side includes a thermally conductive layer. The substrate layer 100 is the same as that in Embodiment 1, and a size design is the same as that in Embodiment 1. The electrically conductive layer is a nickel layer, and a material of the impact-resistant layer is a TPU thin film. A material of the thermally conductive layer is a thermally conductive graphite sheet.

A preparation process of the flexible display support structure in this embodiment is as follows:
(1) The substrate layer is prepared by using a method the same as that in Embodiment 1.
(2) The bendable region of the substrate layer is covered, and acid cleaning is performed on the support member panels on two sides of the bendable region to remove surface oil stain.
(3) The surfaces of the two sides of the support members are catalyzed, and a layer of catalyst containing palladium is deposited on the surfaces of the support members.
(4) The substrate layer is immersed in a plating solution to perform chemical nickel plating for a period of 4 to 12 hours. A nickel layer of 5 µm to 10 µm is deposited on a surface of one side of the substrate layer, and the nickel layer is washed and dried, to form the electrically conductive layer.
(5) A TPU thin film with a thickness of 50 µm to 150 µm is coated on an electrically conductive layer, and the electrically conductive layers are placed in a hot press. Press-fitting is performed at a temperature of 150°C for 30 minutes, to form the impact-resistant layer.
(6) A thermally conductive graphite sheet with a thickness of 30 µm to 100 µm is bonded to the other side of the substrate layer by an adhesive, to obtain the flexible display support structure.

The flexible display support structure prepared in this embodiment has both an electrical conduction function, a thermal conduction function, and an impact resistance function.

### Embodiment 11

Refer to FIG. 8B. A flexible display support structure 30 in this embodiment includes a substrate layer 100 and functional layers 200 disposed on two sides of the substrate layer 100. The functional layer 200 on one side includes an electrically conductive layer 201 and an impact-resistant layer 202, and the functional layer 200 on the other side includes an electrically conductive layer 201 and a thermally conductive layer 202. The substrate layer 100 is the same as that in Embodiment 1, and a size design is the same as that in Embodiment 1. The electrically conductive layer is a nickel layer, and a material of the impact-resistant layer is a TPEE thin film. A material of the thermally conductive layer is a thermally conductive double-sided tape.

A preparation process of the flexible display support structure in this embodiment is as follows:
(1) The substrate layer is prepared by using a method the same as that in Embodiment 1.
(2) The bendable region of the substrate layer is covered, and acid cleaning is performed on the support member panels on two sides of the bendable region to remove surface oil stain.
(3) The surfaces of the two sides of the support members are catalyzed, and a layer of catalyst containing palladium is deposited on the surfaces of the support members.
(4) The substrate layer is immersed in a plating solution to perform chemical nickel plating for a period of 4 to 12 hours. A nickel layer of 5 µm to 10 µm is deposited on surfaces of two sides of the substrate layer, and the nickel layer is washed and dried, to form the electrically conductive layer.
(5) A TPEE thin film with a thickness of 50 µm to 150 µm is coated on an electrically conductive layer on one side of the substrate layer, and the electrically conductive layers are placed in a hot press. Press-fitting is performed at a temperature of 220°C for 30 minutes, to form the thermally conductive layer.
(6) A thermally conductive double-sided tape with a thickness of 30 µm to 100 µm is bonded to the electrically conductive layer on the other side of the substrate layer by gluing, to obtain the flexible display support structure.

The flexible display support structure prepared in this embodiment has an electrical conduction function, a thermal conduction function, and an impact resistance function.

According to the flexible display support structure in embodiments of this application, a composite material of an organic material and fiber is used as the main body material. Compared with an existing flexible display support structure that is completely made of a metal material such as a stainless steel, the weight of the flexible display support structure is greatly reduced, and good rigid support can be provided for a flexible display. In addition, the bending region may be made of a metal material, or may be made of an organic flexible material or a soft rubber fiber composite material, so that the total weight of the support structure is further reduced while bending reliability is ensured, to help reduce the weight of the foldable terminal product, improve product competitiveness, and improve user experience. In addition, the flexible display support structure in embodiments of this application has low preparation costs. In addition, the flexible display support structure in embodiments of this application further has functions such as electrical conduction, thermal conduction, impact resistance, and the like by arranging the functional layers, so that a functional requirement of the support structure can be met, and performance of a terminal product can be improved.

## Claims

1. A composite structure, comprising a substrate layer and a functional layer disposed on a surface of at least one side of the substrate layer, wherein the substrate layer comprises a first support member and a second support member that are disposed side by side and a bendable connecting member that is disposed between the first support member and the second support member and that is connected to the first support member and the second support member, a material of the first support member and the second support member comprises a hard rubber fiber composite material, and the functional layer comprises one or more of an electrically conductive layer, a thermally conductive layer, and an impact-resistant layer.

2. The composite structure according to claim 1, wherein the electrically conductive layer comprises electrically conductive metal, and the electrically conductive layer has a single-layer or multi-layer structure.

3. The composite structure according to claim 2, wherein the electrically conductive metal comprises one or more of copper, silver, gold, nickel, and tin.

4. The composite structure according to any one of claims 1 to 3, wherein the thermally conductive layer comprises one or more of a thermally conductive silicone sheet, a thermally conductive silicone grease, a thermally conductive double-sided tape, a thermally conductive graphite sheet, a graphene sheet, and a graphene oxide sheet.

5. The composite structure according to any one of claims 1 to 4, wherein the impact-resistant layer comprises one or more of silicone rubber, a thermoplastic elastomer, polyurethane acrylate, polyvinyl chloride soft rubber, and polyurethane.

6. The composite structure according to any one of claims 1 to 5, wherein the hard rubber fiber composite material comprises at least one fiber layer and a hard rubber material cured on the fiber layer.

7. The composite structure according to claim 6, wherein the fiber layer comprises unidirectional fiber fabric and/or woven fiber fabric.

8. The composite structure according to claim 6 or 7, wherein the hard rubber material comprises rigid resin and/or rigid rubber.

9. The composite structure according to any one of claims 6 to 8, wherein the hard rubber material comprises one or more of epoxy resin, phenolic resin, amino resin, unsaturated polyester, silyl ether resin, polyolefin, polyamide, polyoxymethylene, polycarbonate, polyphenylene ether, and polysulfone.

10. The composite structure according to any one of claims 6 to 9, wherein the fiber layer comprises one or more of glass fiber, carbon fiber, aramid fiber, aluminum oxide fiber, ultra-high-molecular-weight polyethylene fiber, and poly(p-phenylene benzobisoxazole) fiber.

11. The composite structure according to any one of claims 1 to 10, wherein a mass content of the fiber in the hard rubber fiber composite material is 10% to 80%.

12. The composite structure according to any one of claims 6 to 11, wherein the hard rubber fiber composite material comprises a plurality of fiber layers, and the plurality of fiber layers and the hard rubber material form a composite laminate in which the fiber and hard rubber are alternately laminated; or the plurality of fiber layers are laminated to form a fiber stack, and the hard rubber material is cured on the fiber stack.

13. The composite structure according to any one of claims 1 to 12, wherein a material of the bendable connecting member comprises one or more of an organic flexible material, a soft rubber fiber composite material, a bendable hard rubber fiber composite material, and a bendable metal material.

14. The composite structure according to claim 13, wherein the organic flexible material comprises one or more of fluorine rubber, silicone rubber, a thermoplastic elastomer, polyvinyl chloride, polyimide, polyethylene terephthalate, a cyclic olefin polymer, a liquid crystal polymer, and polydimethylsiloxane.

15. The composite structure according to claim 13, wherein the soft rubber fiber composite material comprises at least one fiber layer and a soft rubber material cured on the fiber layer; and the soft rubber material comprises one or more of fluorine rubber, silicone rubber, and a thermoplastic elastomer.

16. The composite structure according to claim 13 or 15, wherein a mass content of the fiber in the soft rubber fiber composite material is 10% to 80%.

17. The composite structure according to claim 15 or 16, wherein the soft rubber fiber composite material comprises a plurality of fiber layers, and the plurality of fiber layers and the soft rubber material form a composite laminate in which the fiber and soft rubber are alternately laminated; or the plurality of fiber layers are laminated to form a fiber stack, and the soft rubber material is cured on the fiber stack.

18. The composite structure according to claim 13, wherein the bendable metal material comprises one or more of a stainless steel, a titanium alloy, and an aluminum alloy.

19. The composite structure according to claim 13, wherein when the bendable connecting member is made of the soft rubber fiber composite material, the composite structure comprises an integrally woven fiber layer that continuously exists in the first support member, the second support member, and the bendable connecting member.

20. The composite structure according to claim 13, wherein the bendable hard rubber fiber composite material has a porous structure.

21. The composite structure according to claim 13 or 20, wherein when the bendable connecting member is made of the bendable hard rubber fiber composite material, the bendable connecting member and the first support member and/or the second support member have an integrally formed structure.

22. The composite structure according to any one of claims 1 to 21, wherein a thickness of the composite structure is 0.1 mm to 5 mm.

23. A terminal, wherein the terminal comprises the composite structure according to any one of claims 1 to 22.

24. A flexible display assembly, wherein the flexible display assembly comprises a flexible display and a flexible display support structure used for supporting the flexible display, and the flexible display support structure is made by using the composite structure according to any one of claims 1 to 22.

25. A foldable terminal, wherein the foldable terminal comprises the flexible display assembly according to claim 24.

26. The foldable terminal according to claim 25, wherein the flexible display comprises a bending region and non-bending regions on two sides of the bending region, the flexible display support structure is disposed on an outer surface of the flexible display, the first support member and the second support member respectively correspond to the non-bending regions on two sides of the flexible display, and the bendable connecting member corresponds to the bending region of the flexible display.
